(19) Europäisches Patentamt
European Patent Office
Office européen des brevets

(11) Veröffentlichungsnummer: **0 316 618 B1**

(12) # EUROPÄISCHE PATENTSCHRIFT

(45) Veröffentlichungstag der Patentschrift: **17.08.94**

(51) Int. Cl.[5]: **G03F 7/11**

(21) Anmeldenummer: **88117696.0**

(22) Anmeldetag: **25.10.88**

(54) **Mehrschichtiges, flächenförmiges, lichtempfindliches Aufzeichnungsmaterial.**

(30) Priorität: **31.10.87 DE 3736980**

(43) Veröffentlichungstag der Anmeldung:
**24.05.89 Patentblatt 89/21**

(45) Bekanntmachung des Hinweises auf die Patenterteilung:
**17.08.94 Patentblatt 94/33**

(84) Benannte Vertragsstaaten:
**BE DE FR GB IT NL SE**

(56) Entgegenhaltungen:
**FR-A- 2 090 380**
**US-A- 3 458 311**
**US-A- 4 200 463**

(73) Patentinhaber: **BASF Aktiengesellschaft**
**Carl-Bosch-Strasse 38**
**D-67063 Ludwigshafen (DE)**

(72) Erfinder: **Kurtz, Karl-Rudolf, Dr.**
**Schloss-Wolfs-Brunnen-Weg 62**
**D-6900 Heidelberg (DE)**
Erfinder: **Koch, Horst, Dr.**
**Tiefenthaler Strasse 47**
**D-6718 Grünstadt (DE)**
Erfinder: **Telser, Thomas, Dr.**
**Seilerstrasse 26**
**D-6700 Ludwigshafen (DE)**
Erfinder: **Bach, Helmut, Dr.**
**Dahlienstrasse 7**
**D-6704 Mutterstadt (DE)**

**EP 0 316 618 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft ein mehrschichtiges, flächenförmiges, lichtempfindliches Aufzeichnungsmaterial, welches der Herstellung photopolymerisierter Hochdruck-, Tiefdruck-, Flexodruck- und Reliefplatten sowie Photoresists dient und welches die folgenden Schichten in der angegebenen Reihenfolge übereinanderliegend enthält:

A) eine lichtempfindliche reliefbildende Schicht, in welcher bei der bildmäßigen Belichtung mit aktinischem Licht eine Löslichkeitsdifferenzierung zwischen den belichteten und unbelichteten Bereichen eintritt, so daß die Schicht mit organischen, wäßrig-alkoholischen oder wäßrig-alkalischen flüssigen Medien entwickelt werden kann, wobei die Schicht, bezogen auf ihre Gesamtmenge, aus den folgenden Komponenten besteht:

$a_1$) 20 bis 98,999 Gew.% eines oder mehrerer polymerer Bindemittel,

$a_2$) 0,001 bis 10 Gew.% eines oder mehrerer Initiatoren der Photopolymerisation,

$a_3$) 1 bis 60 Gew.% einer oder mehrerer mit dem Bindemittel ($a_1$) verträglicher, photopolymerisierbare olefinisch ungesättigte Gruppen enthaltender Komponenten und

$a_4$) 0 bis 40 Gew.% eines oder mehrerer Hilfsstoffe zur Variation des anwendungstechnischen Eigenschaftsprofils;

B) eine lichtdurchlässige, in den betreffenden flüssigen Medien lösliche oder quellbare, glatte oder mattierte, nicht klebrige Deckschicht, welche an der Schicht (A) fester haftet als an der Deckfolie (C) und welche von einem reißfeste Filme bildenden Polymeren und den darin enthaltenen Zusatzstoffen gebildet wird;

und

C) einer von der Deckschicht (B) leicht ablösbaren Deckfolie.

Hierbei umfaßt der Begriff "flächenförmig" alle Raumformen, deren Dicke erheblich kleiner ist als ihre Länge und Breite, so daß es sich hier um ein band- oder plattenförmiges Aufzeichnungsmaterial handelt.

Unter "flüssigen Medien" sind Lösungsmittel oder Lösungsmittelgemische zu verstehen, die Zusatzstoffe, wie feste, flüssige oder gasförmige, organische und anorganische Verbindungen enthalten können. Diese Medien dienen dem Entwickeln, d.h. dem Auswaschen der bildmäßig belichteten reliefbildenden Schicht (A), und werden daher allgemein kurz als "Entwickler" bezeichnet. Voraussetzung dafür, daß eine bestimmte bildmäßig belichtete reliefbildende Schicht (A) mit einem bestimmten Entwickler ausgewaschen werden kann, ist vor allem die Löslichkeit oder Quellbarkeit des Bindemittels ($a_1$) in dem betreffenden Entwickler. Die Natur des Entwicklers läßt daher auch eindeutige Rückschlüsse auf die stoffliche Zusammensetzung der reliefbildenden Schicht (A) zu.

Der Begriff "verträglich" zeigt an, daß die betreffende Komponente in der reliefbildenden Schicht (A) molekulardispers verteilt werden kann, hierin keine Trübung hervorruft und sich auch im Laufe der Zeit nicht entmischt.

"Photopolymerisierbare olefinisch ungesättigte Gruppen enthaltende Komponenten ($a_3$)" können hier ganz allgemein separat vorliegende Verbindungen sein oder Gruppen, welche als seitenständige oder endständige Reste mit den polymeren Bindemitteln ($a_1$) verknüpft sind. Separat vorliegende Verbindungen werden üblicherweise als "Monomere", und mit Bindemitteln verknüpfte Gruppen werden im folgenden als "photopolymerisierbare Reste" bezeichnet.

Unter "Variation des Eigenschaftsprofils" ist die gezielte Verbesserung bestimmter anwendungstechnischer Eigenschaften von lichtempfindlichen reliefbildenden Schichten (A) und von hieraus hergestellten photopolymerisierten Reliefschichten (A') zu verstehen. Diese Verbesserungen machen sich vor allem bei photopolymerisierte Reliefschichten (A') enthaltenden Hochdruck-, Tiefdruck-, Flexodruck- und Reliefplatten sowie Photoresists bemerkbar und werden allgemein durch Zugabe üblicher und bekannter Zusatzstoffe zu den reliefbildenden Schichten (A) erzielt. Diese Zusatzstoffe werden daher auch als "Hilfsstoffe" bezeichnet.

Die Angabe, daß die Deckschicht (B) fester an der reliefbildenden Schicht (A) haften soll als an der Deckfolie (C) und daß die Deckfolie (C) von der Deckschicht (B) leicht ablösbar sein soll, beinhaltet auch eine stoffliche Präzisierung, weil die unterschiedliche Haftung dieser Schichten aufeinander auf ihre jeweilige stoffliche Zusammensetzung zurückgeht, welche in bekannter Weise eingestellt werden kann.

Die Deckfolie (C) soll dabei von der Deckschicht (B) ohne Beschädigung der letzteren abgelöst werden können.

Mehrschichtige, flächenförmige, lichtempfindliche Aufzeichnungsmaterialien der genannten Art, welche in ihrer Deckschicht (B) neben den reißfeste Filme bildenden Polymeren Zusatzstoffe enthalten, sind bekannt.

So geht aus der DE-A-24 56 439 (US-A-4 162 919) ein Aufzeichnungsmaterial hervor, welches in seiner reliefbildenden Schicht (A) als Bindelmittel ($a_1$) Vinylaromat/Alkadien-Blockmischpolymerisate enthält. Die

reliefbildende Schicht (A) kann nach der bildmäßigen Belichtung mit organischen Entwicklern ausgewaschen werden. Sie ist mit einem harten, klebfreien, transparenten, im Entwickler löslichen, 0,5 bis 20 µm dicken Film aus einem Polyamid oder Copolyamid haftfest verbunden. Dieser Film oder diese Deckschicht (B) kann geringe Mengen, d.h. ≦ 10 Gew.%, bezogen auf (B), an Monomeren, Initiatoren der Photopolymerisation und an Inhibitoren der thermischen Polymerisation enthalten. Dieser Deckschicht (B) kann eine abziehbare Schutz- oder Deckfolie (C) aufliegen, die von (B) abgelöst werden kann, ohne hierbei (B) von (A) zu trennen.

Ein vergleichbares Aufzeichnungsmaterial ist aus der DE-A-28 23 300 bekannt. Hierin wird die Verwendung von Polyurethanen für den Aufbau der Deckschicht (B) angegeben.

Ein weiteres vergleichbares Aufzeichnungsmaterial, dessen reliefbildende Schicht (A) als Bindemittel ($a_1$) Polyalkadiene (Naturkautschuk, Polybutadien), Alkadien/Acrylnitril-Copolymerisate (Butadien/Acrylnitril), Vinylaromat/Alkadien-Copolymerisate (Styrol/Butadien), Silikonkautschuke, Polysulfidkautschuke, Fluorkautschuke (Vinylidenchlorid/Hexafluorpropylen-Copolymerisate), Vinylaromat/Alkadien-Blockmischpolymerisate (Styrol/Isopren, Styrol/Butadien) oder Polyurethane enthält, ist aus der US-A-3 990 897 bekannt.

Desweiteren geht aus der DE-B-21 23 702 ein Aufzeichnungsmaterial hervor, dessen reliefbildende Schicht (A) wäßrig-alkalisch entwickelbar ist und als Bindelmittel ($a_1$) Polyamide, Polyvinylacetate oder Polymethylmethacrylate enthält, und dessen wasserlösliche Deckschicht (B) aus Polyvinylalkohol und einem ethoxylierten Phosphorsäureoleylester besteht.

Aus der US-A-4 072 527 ist ein Aufzeichnungsmaterial bekannt, dessen reliefbildende Schicht (A) nach der bildmäßigen Belichtung wäßrigalkalisch entwickelt werden kann und als Bindemittel ($a_1$), z.B. Methacrylsäure/Methylmethacrylat-Copolymerisate enthält. Die Deckschicht (B) dieses Aufzeichnungsmaterials ist 0,2 bis 25 µm dick und enthält ein wasserlösliches Polymerisat, wie partiell hydrolysiertes Polyvinylacetat, -chloracetat oder -propionat (Hydrolysegrad: 88 bis 100%) und hierin feinteilig dispergiert ein wasserunlösliches Polymerisat aus der Gruppe der (Meth)acrylat-Homo- und -Copolymerisate, aus der Gruppe der Vinylpyrrolidon/Vinylacetat-Copolymerisate oder aus der Gruppe der Vinylidenchlorid/Alkylacrylat/Itaconsäure-Copolymerisate. Diese Deckschicht (B) wird durch Gießen aus wäßriger Lösung hergestellt. Damit die Gießlösung die Oberfläche der reliefbildenden Schicht (A) einwandfrei bedecken kann, soll nach der Patentschrift ein anionisches oder nichtionisches Benetzungsmittel, dort als "surfactant" bezeichnet, in geringer Menge, mitverwendet werden. In Betracht gezogen werden vor allem Natriumalkylsulfate und Sulfonate mit 12 bis 18 Kohlenstoffatomen, wie etwa Natriumdodecylsulfat oder Natriumoctadecylsulfonat; oder Polyethylenglykole eines mittleren Molgewichts von unter 400, wie etwa Isooctylphenylpolyethoxiethanol mit 9 bis 10 Ethoxigruppen. Insbesondere wird die Verwendung des fluorierten Benetzungsmittels

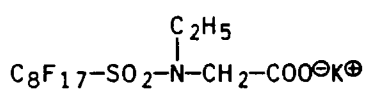

in einer Menge von 1 Gew.%, bezogen auf die Gesamtmenge der Feststoffe in der Gießlösung, empfohlen. Das Aufzeichnungsmaterial der US-A-4 072 527 dient vor allem der Herstellung von Offsetdruckplatten.

Ein hiermit vergleichbares Aufzeichnungsmaterial, dessen Deckschicht (B) neben Polyvinylalkohol eines Hydrolysegrades von über 88% eine geringe Menge Isooctylphenyl-polyethoxiethanol mit 9 bis 10 Ethoxigruppen enthält, ist aus der US-A 3 453 311 (DE-B 15 72 153) oder aus der DE-A-16 22 298 bekannt.

Die bekannten mehrschichtigen, flächenförmigen, lichtempfindlichen Aufzeichnungsmaterialien, welche die Schichten (A), (B) und (C) enthalten, weisen Nachteile auf, welche die Verwendung dieser Aufzeichnungsmaterialien für die Herstellung hochwertiger, besonders detailgetreuer photopolymerisierter Hochdruck-, Tiefdruck-, Flexodruck- und Reliefplatten sowie Photoresists behindern oder gar unmöglich machen.

So hat das Abziehen der Deckfolie (C) von der Deckschicht (B) bei diesen Aufzeichnungsmaterialien eine starke elektrostatische Aufladung der zurückbleibenden Schichten (A) und (B) zur Folge. Diese starke statische Aufladung bewirkt eine Ablagerung von Schmutzpartikeln auf der Oberfläche der Deckschicht (B), wodurch die kopiertechnischen Eigenschaften der Aufzeichnungsmaterialien erheblich verschlechtert werden. Wegen der abgelagerten Schmutzpartikel liegen nämlich die Bildmasken oder Negativvorlagen, durch welche man hindurch belichtet, den Aufzeichnungsmaterialien nicht mehr länger exakt auf, was bei der Belichtung zu einer schlechten Auflösung, zu Problemen bei der Wiedergabe von Zwischentiefen und zu Unterstrahlungen durch Streulicht führt, so daß man insgesamt ein unsauberes Bild erhält, welches höchsten Qualitätsansprüchen nicht genügt. Besonders schwerwiegend macht sich dies bei der Herstellung von photopolymerisierten Hoch-, Tief- und Flexodruckplatten bemerkbar, bei welchen die Schmutzablagerung letztendlich beim Drucken zu einer in ungünstiger Weise veränderten Farbannahme und -abgabe, zu Kantenausbrüchen und zu einer verringerten Reliefhaftung führt, was die Lebensdauer dieser Druckplatten im Endlosdruck erheblich verkürzt. Durch große Schmutzpartikel werden aber auch Kratzer in den photopolymerisierten Reliefschichten (A') hervorgerufen, was sich gerade bei Tiefdruckplatten ganz besonders störend bemerkbar macht, weil diese Kratzer bereits ab einer geringen Tiefe mitdrucken.

Bisher kann man dieser durch die elektrostatische Aufladung bewirkten Ablagerung von Schmutzpartikeln nur dadurch Herr werden, daß man in weitgehend staubfreier Luft arbeitet, was indes in der betrieblichen Praxis meist nicht möglich ist, weil die hierfür notwendigen umfangreichen baulichen und apparativen Voraussetzungen oft fehlen. Aus diesem Grunde behilft man sich häufig mit einer Reinigung der Oberfläche der Deckschicht (B) vor dem Belichten, was indes sowohl arbeitstechnisch als auch wirtschaftlich von Nachteil ist.

Aufgabe der vorliegenden Erfindung ist es, ein neues mehrschichtiges, flächenförmiges, lichtempfindliches Aufzeichnungsmaterial zu finden, welches die Nachteile der bekannten Aufzeichnungsmaterialien nicht mehr länger aufzeigt und welches somit die Herstellung hochwertiger, detailgetreuer photopolymerisierter Hochdruck-, Tiefdruck-, Flexodruck- und Reliefplatten sowie Photoresists ermöglicht.

Demgemäß wurde ein mehrschichtiges, flächenförmiges, lichtempfindliches Aufzeichnungsmaterial gefunden, welches der Herstellung photopolymerisierter Hochdruck-, Tiefdruck-, Flexodruck- und Reliefplatten sowie Photoresists dient und welches die folgenden Schichten in der angegebenen Reihenfolge übereinanderliegend enthält:

A) eine lichtempfindliche reliefbildende Schicht, in welcher bei der bildmäßigen Belichtung mit aktinischem Licht eine Löslichkeitsdifferenzierung zwischen den belichteten und unbelichteten Bereichen eintritt, so daß die Schicht mit organischen, wäßrig-alkoholischen oder wäßrig-alkalischen flüssigen Medien entwickelt werden kann, wobei die Schicht, bezogen auf ihre Gesamtmenge, aus den folgenden Komponenten besteht:

$a_1$) 20 bis 98,999 Gew.% eines oder mehrerer polymerer Bindemittel,

$a_2$) 0,001 bis 10 Gew.% eines oder mehrerer Initiatoren der Photopolymerisation,

$a_3$) 1 bis 60 Gew.% einer oder mehrerer mit dem Bindemittel ($a_1$) verträglicher, photopolymerisierbare olefinisch ungesättigte Gruppen enthaltender Komponenten und

$a_4$) 0 bis 40 Gew.% eines oder mehrerer Hilfsstoffe, mit deren Hilfe das anwendungstechnische Eigenschaftsprofil variiert wird;

B) eine lichtdurchlässige, in den betreffenden flüssigen Medien lösliche oder quellbare, glatte oder mattierte, nicht klebrige Deckschicht, welche an der Schicht (A) fester haftet als an der Deckfolie (C) und welche von einem reißfeste Filme bildenden Polymeren und den darin enthaltenden Zusatzstoffen gebildet wird;

und

C) einer von der Deckschicht (B) leicht ablösbaren Deckfolie;

wobei das Aufzeichnungsmaterial dadurch gekennzeichnet ist, daß die Deckschicht (B), bezogen auf ihre Gesamtmenge, 1 bis 20 Gew.% einer oder mehrerer Verbindungen aus der Gruppe der

$b_1$) tertiären Amine und Amide der allgemeinen Formel I,

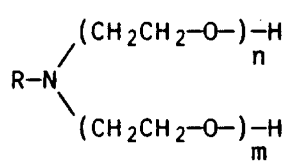

I

worin die Indices und die Variablen die folgende Bedeutung haben:

R $C_{12}$- bis $C_{18}$-Alkyl, $C_{18}$-Alkenyl, $C_{12}$- bis $C_{18}$-Alkancarbonyl oder $C_{18}$-Alkencarbonyl,

n eine ganze Zahl von 1 bis 15 und unabhängig hiervon

m eine ganze Zahl von 1 bis 15;

und/oder aus der Gruppe der

$b_2$) quaternären Ammoniumsalze der allgemeinen Formel II,

$[NR^1R^2R^3R^4]^{\oplus} X^{\ominus}$ II

worin die Variablen die folgende Bedeutung haben:

$X^{\ominus}$ $Cl^{\ominus}$, $Br^{\ominus}$, $I^{\ominus}$, $R^1$-O-$PO_3H^{\ominus}$, $(R^1\text{-O})_2PO_2^{\ominus}$, $R^1$-$PO_3^{\ominus}$, $R^1$-$SO_3^{\ominus}$, R1-$COO^{\ominus}$, $CF_3SO_3^{\ominus}$, $R^1$-

| | |
|---|---|
| | $OSO_3^{\ominus}$, |
| $R^1$ | $C_1$- bis $C_4$-Alkyl, |
| $R^2$ und $R^3$ | $C_1$- bis $C_{20}$-Alkyl, |
| | $-(-CH_2CH_2-O-)_n-H$, worin n eine ganze Zahl von 1 bis 15 bezeichnet und wobei $R^2$ und $R^3$ gleich oder verschieden sein können, |
| $R^4$ | $-(-CH_2CH_2-O-)_n-H$, worin n eine ganze Zahl von 1 bis 15 bezeichnet, |
| | $C_{12}$-, $C_{14}$-, $C_{16}$- und $C_{18}$-Alkyl, |
| | 3-Azatridecan-1-yl bis 3-Azadocosan-1-yl, |
| | 4-Azatridecan-1-yl bis 4-Azadocosan-1-yl, |
| | 3-Aza-4-oxo-tridecan-1-yl bis 3-Aza-4-oxo-docosan-1-yl, |
| | 4-Aza-5-oxo-tridecan-1-yl bis 4-Aza-5-oxo-docosan-1-yl, |
| | 3-Oxa-tridecan-1-yl bis 3-Oxa-docosan-1-yl, |
| | 4-Oxa-tridecan-1-yl bis 4-Oxadocosan-1-yl, |
| | 2-Hydroxy-4-oxa-tridecan-1-yl bis 2-Hydroxy-4-oxa-docosan-1-yl, |

enthält.

Wesentlicher Bestandteil des erfindungsgemäßen, mehrschichtigen, flächenförmigen, lichtempfindlichen Aufzeichnungsmaterials - im folgenden kurz als "erfindungsgemäßes Aufzeichnungsmaterial" bezeichnet - ist die neue Deckschicht (B).

Die neue Deckschicht (B) ist üblicherweise 0,2 bis 25 µm dick und bedeckt die unter ihr liegende lichtempfindliche reliefbildende Schicht (A) vollständig und in gleichmäßiger Dicke. Sie ist lichtdurchlässig und stört somit nicht die bildmäßige Belichtung der reliefbildenden Schicht (A) mit aktinischem Licht. Sie ist in den Entwicklern, mit denen die bildmäßig belichtete reliefbildende Schicht (A) ausgewaschen wird, löslich oder zumindest quellbar, so daß sie bei der Entwicklung vollständig von der photopolymerisierten Reliefschicht (A') entfernt werden kann. Im allgemeinen ist sie sauerstoffundurchlässig, so daß sie eine Inhibierung der Photopolymerisation durch Luftsauerstoff in der reliefbildenden Schicht (A) verhindert. Sie ist nicht klebrig, so daß eine auf sie aufgelegte Bildmaske oder Negativvorlage leicht wieder vom Aufzeichnungsmaterial abgelöst werden kann, und haftet an der reliefbildenden Schicht (A) fester als an der ihr aufliegenden Deckfolie (C).

Die neuartige Deckschicht (B) kann glatt sein, d.h. sie kann einen Oberflächenrauhwert $R_{max} \leqq 0{,}1$ µm aufweisen. Vorteilhafterweise ist sie mattiert, d.h. ihr Oberflächenrauhwert $R_{max}$ liegt bei 0,1 bis 15, vorzugsweise 0,3 bis 10 und insbesondere 0,5 bis 7 µm. Durch die Mattierung wird die Zeit, in der die Bildmaske oder Negativvorlage mit dem Aufzeichnungsmaterial in Kontakt gebracht werden kann, erheblich verkürzt.

Sofern die Dicke der neuen Deckschicht (B) geringer ist als ihr Oberflächenrauhwert $R_{max}$, ist die unter der Deckschicht (B) liegende Oberfläche der reliefbildenden Schicht (A) gleichfalls mattiert, was oftmals von Vorteil ist.

Die neue Deckschicht (B) enthält, bezogen auf ihre Gesamtmenge, 80 bis 99 Gew.%, insbesondere 85 bis 98 Gew.% eines reißfeste Filme bildenden Polymeren. Beispiele für solche Polymere sind Polymere aus der Gruppe der Polyamide, Copolyamide, Polyurethane, Poly(meth)acrylate, Polyvinylalkohol-alkancarbonsäureester eines Hydrolysegrades von 30 bis 99%, der Cyclokautschuke hohen Cyclisierungsgrades, der Ethylen/Propylen-Copolymerisate, der Homo- und Copolymerisate des Vinylchlorids sowie der Ethylen/Vinylacetat-Copolymerisate. Polymere dieser Art sind allgemein bekannt. Die Auswahl des Polymeren für den Aufbau der Deckschicht (B) richtet sich in erster Linie nach den Löslichkeitseigenschaften des Polymeren einerseits und der hiermit zu bedeckenden reliefbildenden Schicht (A) andererseits: Die Löslichkeiten, welche allgemein bekannt sind, sind so aufeinander abzustimmen, daß beide Schichten (A) und (B) mit ein und demselben Entwickler aus- bzw. weggewaschen werden können.

Enthält die neue Deckschicht (B) weniger als 80 Gew.% an dem Polymeren, so ist eine konstante Dicke über die gesamte reliefbildende Schicht (A) hinweg nur noch schwer einzustellen, außerdem kann sie dann ihre Schutzfunktion und ihre Antiklebewirkung nicht mehr voll entfalten.

Enthält die neue Deckschicht (B) mehr als 99 Gew.% an dem Polymeren, so ist ihre schmutzabweisende Wirkung merklich geringer.

Hinsichtlich der schmutzabweisenden Wirkung einerseits und den übrigen anwendungstechnischen Eigenschaften andererseits stellt ein Gehalt der Deckschicht (B) an dem Polymeren von 85 bis 98 Gew.% ein Optimum dar.

Erfindungsgemäß enthält die neue Deckschicht (B), bezogen auf ihre Gesamtmenge, 1 bis 20 Gew.%, insbesondere 2 bis 15 Gew.% einer oder mehrerer Verbindungen aus der Gruppe der tertiären Amine und Amide ($b_1$) der allgemeinen Formel I und/oder aus der Gruppe der quaternären Ammoniumsalze ($b_2$) der allgemeinen Formel II.

Enthält die neue Deckschicht (B) weniger als 1 Gew.% der erfindungsgemäß zu verwendenden Verbindungen ($b_1$) und ($b_2$), so ist ihre schmutzabweisende Wirkung merklich geringer.

Enthält die neue Deckschicht (B) dagegen mehr als 20 Gew.% der erfindungsgemäß zu verwendenden Verbindungen ($b_1$) und ($b_2$), so ist ihre schmutzabweisende Wirkung zwar hoch, so daß es zu keiner Ablagerung von Schmutzpartikeln hierauf kommt, sie weist indes in ihren übrigen anwendungstechnischen Eigenschaften keine weiteren Vorteile auf.

Hinsichtlich der schmutzabweisenden Wirkung einerseits und den übrigen anwendungstechnischen Eigenschaften andererseits stellt ein Gehalt der Deckschicht (B) an den erfindungsgemäß zu verwendenden Verbindungen ($b_1$) und/oder ($b_2$) von 2 bis 15 Gew.% ein Optimum dar.

Beispiele erfindungsgemäß anzuwendender Reste R in tertiären Aminen und Amiden ($b_1$) der allgemeinen Formel I sind Dodecyl( = Lauryl)-, Tridecyl-, Tetradecyl( = Myristyl)-, Pentadecyl-, Hexadecyl( = Palmityl)-, Heptadecyl-, Octadecyl( = Stearyl)-, Oleyl-, 1-Oxo-dodecan-1-yl-, 1-Oxo-tridecan-1-yl-, 1-Oxo-tridecan-1-yl-, 1-Oxo-tetradecan-1-yl-, 1-Oxo-pentadecan-1-yl-, 1-Oxo-hexadecan-1-yl-, 1-Oxo-heptadecan-1-yl-, 1-Oxo-octadecan-1-yl- oder 1-Oxo-octadec-9-en-1-yl-Reste.

Die erfindungsgemäß zu verwendenden Amine und Amide ($b_1$) werden im allgemeinen, durch Ethoxylierung von Aminen, wie Dodecyl( = Lauryl)-, Tridecyl-, Tetradecyl( = Myristyl)-, Pentadecyl-, Hexadecyl-( = Palmityl)-, Oktadecyl( = Stearyl)- oder Oleylamin oder deren Gemische oder durch Ethoxylierung von Amiden, wie Laurinsäure-, Tridecancarbonsäure-, Myristinsäure-, Pentadecancarbonsäure-, Palmitinsäure-, Heptadecancarbonsäure-, Stearinsäure- oder Ölsäureamid gebildet. Hierbei werden jeweils zwei 2-Hydroxyethylgruppen mit einem Stickstoffatom verknüpft, was der Bedingung n und m = 1 der allgemeinen Formel I entspricht. Es werden indes hierbei auch ein oder zwei längerkettige $\omega$-Hydroxy-poly(ethylenoxid)-$\alpha$-yl-Reste mit einem Stickstoffatom verknüpft, wobei diese Reste unabhängig voneinander bis zu 15, vorzugsweise 5 bis 12 und insbesondere 8 bis 11 Ethylenoxideinheiten aufweisen. Wird hierbei nur ein langkettiger Rest mit dem Stickstoffatom verknüpft, so handelt es sich bei dem anderen Rest um eine 2-Hydroxyethylgruppe. Bevorzugt wird die Verknüpfung zweier 2-Hydroxyethylgruppen mit einem Stickstoffatom.

Beispiele besonders vorteilhafter tertiärer Amine und Amide ($b_1$) sind demnach N,N-Bis-(2-hydroxyethyl)-N-dodecyl( = lauryl)-, -N-tridecyl-, -N-tetradecyl( = myristyl)-, -N-pentadecyl-, -N-hexadecyl( = palmityl)-, -N-heptadecyl-, -N-stearyl- oder -N-oleylamin oder deren Gemische; oder N,N-Bis-(2-hydroxyethyl)-laurinsäure-, -tridecancarbonsäure-, -myristinsäure-, -pentadecancarbonsäure-, -palmitinsäure-, -heptadecancarbonsäure-, -stearinsäure- oder -ölsäureamid oder deren Gemische; sowie alle jene Gemische, die diese Amine und Amide nebeneinander enthalten.

Beispiele erfindungsgemäß anzuwendender Reste $R^1$ in quaternären Ammoniumsalzen ($b_2$) der allgemeinen Formel II sind Methyl-, Ethyl-, n-Propyl-, i-Propyl-, n-Butyl- oder i-Butyl-Reste.

Beispiele geeigneter Anionen $X^{\ominus}$ in quaternären Ammoniumsalzen ($b_2$) der allgemeinen Formel II sind Chlorid, Bromid, Iodid, $R^1$-O-$PO_3H^{\ominus}$, $(R^1\text{-O})_2PO_2^{\ominus}$, $R^1$-$PO_3^{\ominus}$, $R^1$-$SO_3^{\ominus}$, $R^1$-$COO^{\ominus}$, $CF_3SO_3^{\ominus}$ oder $R^1$-$OSO_3^{\ominus}$, worin $R^1$ die vorstehend angegebene Bedeutung hat.

Beispiele erfindungsgemäß anzuwendender Reste $R^2$ und $R^3$ in quaternären Ammoniumsalzen ($b_2$) der allgemeinen Formel II sind Methyl-, Ethyl-, n-Propyl-, i-Propyl-, n-Butyl-, i-Butyl-, n-Pentyl-, n-Hexyl-, n-Heptyl-, n-Octyl-, i-Octyl-, n-Nonyl-, n-Decyl-, n-Undecyl-, n-Dodecyl( = Lauryl)-, n-Tridecyl-, n-Tetradecyl-( = Myristyl)-, n-Pentadecyl-, n-Hexadecyl( = Palmityl)-, n-Heptadecyl-, Stearyl-, n-Nonadecyl- oder n-Eicosanyl-Reste oder 2-Hydroxyethyl- oder $\omega$-Hydroxy-poly(ethylenoxid)-$\alpha$-yl-Reste mit 2 bis 15, vorzugsweise 5 bis 12 und insbesondere 8 bis 11 Ethylenoxideinheiten in der Kette. Hierbei sind $R^2$ und $R^3$ gleich oder verschieden voneinander.

Beispiele erfindungsgemäß anzuwendender Reste $R^4$ in quaternären Ammoniumsalzen ($b_2$) der allgemeinen Formel II sind 2-Hydroxyethyl- oder $\omega$-Hydroxypoly(ethylenoxid)-$\alpha$-yl-Reste mit 2 bis 15, vorzugsweise 5 bis 12 und insbesondere 8 bis 11 Ethylenoxideinheiten in der Kette; oder Lauryl-, Myristyl-, Palmityl- oder Stearyl-Reste; oder 3-Aza-tridecan-1-yl-, 3-Azatetradecan-1-yl-, 3-Aza-pentadecan-1-yl( = 2-Laurylaminoethyl)-, 3-Aza-hexadecan-1-yl-, 3-Aza-heptadecan-1-yl( = 2-Myristylaminoethyl)-, 3-Aza-octadecan-1-yl-, 3-Aza-nonadecan-1-yl( = 2-Palmitylaminoethyl)-, 3-Aza-eicosan-1-yl-, 3-Azaheneicosan-1-yl( = 2-Stearylaminoethyl)- oder 3-Aza-docosan-1-yl-Reste; oder 4-Aza-tridecan-1-yl-, 4-Aza-tetradecan-1-yl-, 4-Azapentadecan-1-yl-, 4-Aza-hexadecan-1-yl( = 3-Laurylaminopropyl)-, 4-Aza-heptadecan-1-yl-, 4-Aza-octadecan-1-yl( = 3-Myristylaminopropyl)-, 4-Aza-nonadecan-1-yl-, 4-Aza-eicosan-1-yl( = 3-Palmitylaminopropyl)-, 4-Aza-heneicosan-1-yl- oder 4-Aza-docosan-1-yl- bzw. 3-stearylaminopropyl-Reste; oder 3-Aza-4-oxo-tridecan-1-yl-, 3-Aza-4-oxo-tetradecan-1-yl-, 3-Aza-4-oxo-pentadecan-1-yl( = 2-Laurylamidoethyl)-, 3-Aza-4-oxo-hexadecan-1-yl-, 3-Aza-4-oxo-heptadecan-1-yl( = 2-Myristylamidoethyl)-, 3-Aza-4-oxo-octadecan-1-yl-, 3-Aza-4-oxo-nonadecan-1-yl-( = 2-Palmitylamidoethyl)-, 3-Aza-4-oxo-eicosan-1-yl-, 3-Aza-4-oxo-heneicosan-1-yl-( = 2-Stearylamidoethyl)- oder 3-Aza-4-oxo-docosan-1-yl-Reste; oder 4-Aza-5-oxo-tridecan-1-yl-, 4-Aza-5-oxo-tetradecan-1-yl-, 4-Aza-5-oxo-pentadecan-1-yl-,4-Aza-5-oxo-hexadecan-1-yl( = 3-Laurylamidopropyl)-, 4-Aza-5-oxo-heptadecan-1-yl-, 4-Aza-5-oxo-octadecan-1-yl( = 3-Myristylamidopropyl)-, 4-Aza-5-oxo-nonadecan-1-yl-, 4-Aza-5-oxo-eicosan-1-yl-( = 3-Palmitylamidopropyl)-, 4-Aza-5-oxo-heneicosan-1-yl- oder 4-Aza-5-oxo-docosan-1-yl- bzw. 3-Stearylamidopropyl-Reste; oder 3-Oxa-tridecan-1-yl-, 3-Oxa-tetradecan-1-yl-, 3-Oxa-pentadecan-1-yl( = 2-Lauryloxiethyl)-, 3-Oxa-hexadecan-1-yl-, 3-Oxa-heptadecan-1-yl( = 2-Myristyloxiethyl)-, 3-Oxa-octadecan-1-yl-, 3-Oxa-nonadecan-1-yl( = 2-Palmityloxiethyl)-, 3-Oxa-eicosan-1-yl-,3-Oxa-heneicosan-1-yl-( = 2-Stearyloxiethyl)- oder 3-Oxa-docosan-1-yl-Reste; oder 4-Oxa-tridecan-1-yl-, 4-Oxa-tetradecan-1-yl-, 4-Oxa-pentadecan-1-yl-, 4-Oxa-hexadecan-1-yl( = 3-Lauryloxipropyl)-, 4-Oxa-heptadecan-1-yl-, 4-Oxa-octadecan-1-yl( = 3-Myristyloxipropyl)-, 4-Oxa-nonadecan-1-yl-, 4-Oxa-eicosan-1-yl( = 3-Palmityloxipropyl)-, 4-Oxa-heneicosan-1-yl- oder 4-Oxa-docosan-1-yl- bzw. 3-Stearyloxipropyl-Reste; oder 2-Hydroxy-4-oxa-tridecan-1-yl-, 2-Hydroxy-4-oxa-tetradecan-1-yl-, 2-Hydroxy-4-oxa-pentadecan-1-yl-, 2-Hydroxy-4-oxa-hexadecan-1-yl-( = 3-Lauryloxi-2-hydroxypropyl)-, 2-Hydroxy-4-oxaheptadecan-1-yl-, 2-Hydroxy-4-oxa-octadecan-1-yl ( = 3-Myristyloxi-2-hydroxypropyl)-,2-Hydroxy-4-oxa-nonadecan-1-yl-, 2-Hydroxy-4-oxa-eicosan-1-yl( = 3-Palmityloxi-2-hydroxypropyl)-, 2-Hydroxy-4-oxa-heneicosan-1-yl- oder 2-Hydroxy-4-oxa-docosan-1-yl- bzw. 3-Stearyloxi-2-hydroxypropyl-Reste.

Beispiele für Reste $R^1$, die mit besonderem Vorteil in quaternären Ammoniumsalzen ($b_2$) der allgemeinen Formel II verwendet werden, sind Methyl- und Ethylreste.

Beispiele für Reste $R^2$ und $R^3$, die mit besonderem Vorteil in den quaternären Ammoniumsalzen ($b_2$) der allgemeinen Formel II verwendet werden, sind Methyl-, Ethyl-, Lauryl-, Myristyl-, Palmityl-, Stearyl- oder 2-Hydroxyethyl-Reste.

Beispiele für Reste $R^4$, die mit besonderem Vorteil in den quaternären Ammoniumsalzen ($b_2$) verwendet werden, sind 2-Hydroxyethyl-, Lauryl-, Myristyl-, Palmityl-, Stearyl-, 2-Laurylaminoethyl-, 2-Myristylaminoethyl-, 2-Palmitylaminoethyl-, 2-Stearylaminoethyl-, 3-Laurylaminopropyl-, 3-Myristylaminopropyl-, 3-Stearylaminopropyl-, 2-Laurylamidoethyl-, 2-Myristylamidoethyl-, 2-Palmitylamidoethyl-, 2-Stearylamidoethyl-, 3-Laurylamidopropyl-, 3-Myristylamidopropyl-, 3-Palmitylamidopropyl-, 3-Stearylamidopropyl-, 2-Lauryloxiethyl-, 2-Myristyloxiethyl-, 2-Palmityloxiethyl-, 2-Stearyloxiethyl-, 3-Lauryloxipropyl-, 3-Myristyloxipropyl-, 3-Stearyloxipropyl-, 3-Lauryloxi-2-hydroxypropyl-, 3-Myristyloxi-2-hydroxypropyl-, 3-Palmityloxi-2-hydroxypropyl- oder 3-Stearyloxi-2-hydroxypropyl-Reste.

Das Anion, welches mit besonderem Vorteil in den quaternären Ammoniumsalzen ($b_2$) der allgemeinen Formel II verwendet wird, ist Ethylsulfat.

Beispiele für besonders vorteilhafte erfindungsgemäß anzuwendende quaternäre Ammoniumsalze ($b_2$) der allgemeinen Formel II sind:

N-Methyl-N,N-bis-(2-hydroxyethyl)-N-lauryl-, -N-myristyl-, -N-palmityl- oder -N-stearyl-ammonium-ethylsulfat;

oder

N-Methyl-N,N-bis-(2-hydroxyethyl)-N-(2-laurylaminoethyl)-, -N-(2-myristylaminoethyl)-, -N-(2-palmitylaminoethyl)- oder -N-(2-stearylaminoethyl)-ammonium-ethylsulfat;

oder

N,N-Dimethyl-N-(2-hydroxyethyl)-N-(3-laurylaminopropyl)-, -N-(3-myristylaminopropyl)-, -N-(3-palmitylaminopropyl)- oder -N-(3-stearylaminopropyl)-ammonium-ethylsulfat;

oder

N,N,N-Trimethyl-N-(2-hydroxyethyl)-ammonium-ethylsulfat;

oder

N,N-Dimethyl-N-(2-hydroxyethyl)-N-(2-laurylamidoethyl)-, -N-(2-myristylamidoethyl)-, -N-(2-palmitylamidoethyl)- oder -N-(2-stearylamidoethyl)-ammonium-ethylsulfat;

oder

N,N-Dimethyl-N-(2-hydroxyethyl)-N-(3-laurylamidopropyl)-, -N-(3-myristylamidopropyl)-, -N-(3-palmitylamidopropyl)- oder -N-(3-stearylamidopropyl)-ammonium-ethylsulfat;

oder

N-Methyl-N,N-bis-(2-hydroxyethyl)-N-(2-lauryloxiethyl)-, -N-(2-myristyloxiethyl)-, -N-(2-palmityloxiethyl)- oder -N-(2-stearyloxiethyl)-ammonium-ethylsulfat;

oder

N,N-Dimethyl-N-(2-hydroxyethyl)-N-(3-lauryloxipropyl)-, -N-(3-myristyloxipropyl)-, -N-(3-palmityloxipropyl)- oder -N-(3-stearyloxipropyl)-ammonium-ethylsulfat;

oder

N-Methyl-N,N-bis-(2-hydroxyethyl)-N-(3-lauryloxi-2-hydroxypropyl)-, -N-(3-myristyloxi-2-hydroxypropyl)-, -N-(3-palmityloxi-2-hydroxypropyl)-oder -N-(3-stearyloxi-2-hydroxypropyl)-ammonium-ethylsulfat;

oder

N,N-Dimethyl-N-(2-hydroxyethyl)-N-(3-lauryloxi-2-hydroxypropyl)-,-N-(3-myristyloxi-2-hydroxypropyl)-, -N-(3-palmityloxi-2-hydroxypropyl)- oder -N-(3-stearyloxi-2-hydroxypropyl)-ammonium-ethylsulfat.

Die quaternären Ammoniumsalze ($b_2$) der allgemeinen Formel II werden einzeln oder als Gemisch aus mehreren der Ammoniumsalze ($b_2$) angewendet. Sie werden auch als Gemische mit den tertiären Aminen und Amiden ($b_1$) verwendet. Von besonderem Vorteil ist es indes, die tertiären Amine und Amide ($b_1$) oder die quaternären Ammoniumsalze ($b_2$) getrennt anzuwenden. Von ganz besonderem Vorteil ist hierbei, Gemische aus tertiären Aminen und Amiden ($b_1$) oder Gemische aus quaternären Ammoniumsalzen ($b_2$) zu verwenden. Solche Gemische sind bekannt und im Handel erhältlich. Beispielsweise werden von der Firma Georg M. Langer und Co. Gemische und Lösungen von quaternären Ammoniumsalzen ($b_2$) der allgemeinen Formel II unter den Markennamen ®Catafor CA 100, CA 80 (Lösung in Butanol), BCA 100 oder BCA 80 (Lösung in Butanol) sowie tertiäre Amine und Amide ($b_1$) der allgemeinen Formel I unter dem Markennamen ®Catafor 06 vertrieben. Diese Amine und Amide ($b_1$) finden sich auch unter Handelsnamen, wie ®Armostat 600 von Akzo oder ®Antistatikum Hoechst VP FA 14 von Hoechst im Markt.

Die Herstellung der erfindungsgemäß anzuwendenden neuen Deckschicht (B) erfolgt üblicherweise bei der Herstellung des erfindungsgemäßen Aufzeichnungsmaterials und wird deshalb im dies betreffenden Passus beschrieben.

Ein weiterer wesentlicher Bestandteil des erfindungsgemäßen Aufzeichnungsmaterials ist die lichtempfindliche reliefbildende Schicht (A), in welcher bei der bildmäßigen Belichtung mit aktinischem Licht eine Löslichkeitsdifferenzierung zwischen den belichteten und unbelichteten Bereichen eintritt, so daß die Schicht mit organischen, wäßrig-alkoholischen oder wäßrig-alkalischen flüssigen Medien entwickelt werden kann.

Die lichtempfindliche reliefbildende Schicht (A) enthält bezogen auf ihre Gesamtmenge 20 bis 98,999, vorzugsweise 30 bis 95 und insbesondere 40 bis 90 Gew.% eines oder mehrerer polymerer Bindemittel ($a_1$).

Erfindungsgemäß geeignete Bindemittel ($a_1$) entstammen den Polymerklassen der Polyamide, Copolyamide, Polyester, Polyurethane, Polyalkadiene, der Vinylaromat/Alkadien-Copolymerisate und -Blockmischpolymerisate, Alkadien/Acrylnitril-Copolymerisate, Butylkautschuke, Acrylatkautschuke, Polychloroprene, Fluorkautschuke, Polysulfidkautschuke, Silikonkautschuke, Ethylen/Propylen-Copolymerisate, der chlorsulfonierten Polyethylene, der Ethylen/(Meth)Acrylat-, Ethylen/Vinylacetat- und Ethylen/(Meth)Acrylsäure-Copolymerisate und der (Meth)Acrylsäure/(Meth)Acrylat-Copolymerisate, bzw. werden für die Verwendung aus dieser Gruppe ausgewählt. Diese als Bindemittel ($a_1$) geeigneten Polymeren sind bekannte Verbindungen und werden durch übliche und bekannte Methoden der Polymerchemie erhalten.

Besonders vorteilhafte Bindemittel ($a_1$) entstammen den Polymerklassen der Polyamide, Copolyamide, Polyalkadiene, Vinylaromat/Alkadien-Copolymerisate und -Blockmischpolymerisate, Alkadien/Acrylnitril-Copolymerisate und der Ethylen/(Meth)Acrylsäure-Copolymerisate, bzw. werden aus dieser Gruppe für die Verwendung ausgewählt.

Beispiele besonders vorteilhafter Bindemittel ($a_1$) aus der Polymerklasse der Polyamide und Copolyamide sind lineare Homo- und Copolyamide, die in bekannter Weise aus bifunktionellen Carbonsäuren und Diaminen oder aus $\omega$-Aminosäuren, Lactamen oder aus geeigneten Derivaten dieser Verbindungen hergestellt werden, wie Nylon 3, 4, 5, 6, 8, 11, 12, 13, 6.6., 6.10 oder 6.13; oder ein Polyamid aus Metaxylylendiamin und Adipinsäure oder aus Trimethyl-hexamethylendiamin oder Isophorondiamin und Adipinsäure; oder Nylon 6/6.6, 6/6.6/6.10 oder 6/6.6/6.10/6.12; oder ein Polyamid aus $\epsilon$-Caprolactam/Adipinsäure/Hexamethylendiamin/4,4-Diaminodicyclohexylmethan oder aus $\epsilon$-Caprolactam/Adipinsäure/Hexamethylendiamin/Polyethylenglykoldiamin; oder die N-Methylol- oder N-Alkoximethylderivate all dieser Homo- und Copolyamide; oder Homo- und Copolyamide der genannten Art, welche photopolymerisierbare Reste ($a_3$) enthalten.

Beispiele besonders vorteilhafter Bindemittel ($a_1$) aus der Polymerklasse der Alkadiene sind Naturkautschuk, die Homopolymerisate von Butadien oder Isopren, Butadien/Isopren-Copolymerisate oder die entsprechenden Polymerisate mit photopolymerisierbaren Resten ($a_3$).

Beispiele besonders vorteilhafter Bindemittel ($a_1$) aus der Polymerklasse der Vinylaromat/Alkadien-Copolymerisate sind Copolymerisate aus Styrol und Butadien und/oder Isopren mit statistischer Verteilung der einpolymerisierten Monomeren und einem Gehalt an einpolymerisiertem Styrol von vorzugsweise 10 bis 50 Gew.% oder die entsprechenden Copolymerisate mit photopolymerisierbaren Resten ($a_3$).

Beispiele besonders vorteilhafter Bindemittel ($a_1$) aus der Polymerklasse der Vinylaromat/Alkadien-Blockmischpolymerisate sind diejenigen, welche mindestens einen elastomeren Dien-Polymerisatblock X und mindestens einen thermoplastischen Vinylaromaten-Polymerisat-Block Y enthalten, wobei die Blöcke X und Y im allgemeinen über Kohlenstoff-Kohlenstoff-Bindungen chemisch miteinander verknüpft sind. In einem gegebenen Blockcopolymerisat kann die Verknüpfung von einem Block X mit einem Block Y auch durch ein statistisches oder ein alternierendes Copolymeres, welches konjugierte Diene und Vinylaromaten

einpolymerisiert enthält, erfolgen; oder aber die Verknüpfung der Blöcke X und Y erfolgt mittels eines Copolymerisats aus konjugierten Dienen und Vinylaromaten, in welchem die Konzentration einpolymerisierter konjugierter Diene vom Block X zum Block Y hin ab- und die Konzentration einpolymerisierter Vinylaromaten zunimmt.

Darüber hinaus können die Blockmischpolymerisate über geeignete mehrbindige Atome oder Ionen sowie anorganische, organische oder metallorganische Molekülreste zu noch größeren Blockmischpolymerisat-Verbänden verknüpft werden. Dabei ist unter Verknüpfung die Bildung kovalenter oder ionischer Bindungen zwischen zwei Molekülresten zu verstehen.

Außerdem können die olefinischen und aromatischen Bindungen oder auch nur die olefinischen Bindungen in den Dienpolymerisat-Blöcken X partiell oder vollständig hydriert vorliegen. Zudem können die Blöcke X und Y weitere Monomere, bei welchen es sich nicht um konjugierte Diene und Vinylaromaten handeln muß, einpolymerisiert enthalten, wie beispielsweise Acrylnitril, Acrylsäure, Maleinsäureanhydrid, (Meth)Acrylsäureamide oder (Meth)acrylsäureester, wobei deren Anteil am Blockmischpolymerisat im allgemeinen 10 Gew.% nicht übersteigen soll. Dabei können die Blöcke X auch Vinylaromaten einpolymerisiert enthalten, wobei deren Menge so gewählt wird, daß sie die elastomeren Eigenschaften der Blöcke X nicht beeinträchtigt. Ebenso können die Blöcke Y so viele konjugierte Diene einpolymerisiert enthalten, daß ihre thermoplastische Verarbeitbarkeit nicht verloren geht. überdies können die Blockmischpolymerisate photopolymerisierbare Reste ($a_3$) enthalten.

Enthält dabei ein Blockmischpolymerisat mehrere elastomere Blöcke X und/oder mehrere thermoplastische Blöcke Y, dann müssen die Blöcke X bzw. Y nicht jeweils chemisch identisch oder angenähert gleich sein, sondern sie können sich jeweils deutlich voneinander unterscheiden, sofern sie stets die erforderlichen elastomeren bzw. thermoplastischen Eigenschaften aufweisen.

Im allgemeinen weisen Blöcke X eine Glastemperatur Tg von unterhalb 20 °C, vorzugsweise unterhalb 0 °C und insbesondere unterhalb -15 °C auf. Diese Blöcke können im allgemeinen eine mittlere Molmasse von $10^3$ bis $2.10^5$ aufweisen. Im allgemeinen enthalten sie 30 bis 100, insbesondere 30 bis 95 Gew.%, bezogen auf den jeweiligen Block X, an einpolymerisierten konjugierten Dienen.

Blöcke Y weisen im allgemeinen eine Glastemperatur Tg von mehr als 20 °C auf. Sie haben im allgemeinen eine mittlere Molasse von $1{,}5.10^3$ bis $2.10^6$, vorzugsweise $5.10^3$ bis $1{,}5.10^6$ und insbesondere $10^4$ bis $1{,}2.10^6$. Sie enthalten im allgemeinen 30 bis 100, insbesondere 40 bis 90 Gew.%, bezogen auf den jeweiligen Block Y, an einpolymerisierten Vinylaromaten.

Beispiele für vorteilhafte konjugierte Diene sind Butadien, Isopren, Pentan-1,3-dien, 2,3-Dimethylbutadien oder Hexan-2,4-dien, wobei Butadien und/oder Isopren bevorzugt sind.

Beispiele für vorteilhafte Vinylaromaten sind Styrol, $\alpha$-Methylstyrol, p-Methylstyrol, p-tert.-Butylstyrol oder 1-Vinylnaphthalin, wobei Styrol bevorzugt ist.

Als Beispiele für besonders vorteilhafte Blockmischpolymerisate seien die thermoplastisch elastomeren Dreiblockmischpolymerisate Y-X-X' angeführt, in denen Y einen thermoplastischen, nicht elastischen Styrolpolymerisat-Block, X einen elastomeren Butadien- und/oder Isoprenpolymerisat-Block und X' einen von X verschiedenen elastomeren Polymerisat-Block aus einpolymerisiertem Butadien und/oder Isopren sowie gegebenenfalls einpolymerisiertem Styrol darstellt.

Als weitere Beispiele für besonders vorteilhafte Blockmischpolymerisate seien Vierblockmischpolymerisate, wie X-Y-X-Y, Y-X-X'-Y, Y-X-Y-X' oder X-X'-Y-X angeführt.

Beispiele besonders vorteilhafter Bindemittel ($a_1$) aus der Polymerklasse der Alkadien/Acrylnitril-Copolymerisate sind die Nitrilkautschuke, wie Butadien/Acrylnitril-Copolymerisate mit einem Acrylnitrilgehalt von 15 bis 40 Gew.%, oder Nitrilkautschuke der genannten Art mit photopolymerisierbaren Resten ($a_3$).

Beispiele besonders vorteilhafter Bindemittel ($a_1$) aus der Polymerklasse der Ethylen/(Meth)Acrylsäure-Copolymerisate sind diejenigen, welche durch Copolymerisation von Monomerengemischen erhältlich sind, die aus

$a_{11}$) Ethylen,

$a_{12}$) Acrylsäure und/oder Methacrylsäure und aus

$a_{13}$) einem oder mehreren weiteren Monomeren aus der Gruppe der Vinylester, Vinylether, Acrylsäureester, Methacrylsäureester, Acrylsäureamide und Methacrylsäureamide

bestehen und für deren Gewichtsverhältnisse die folgenden Bedingungen gelten:

Gew.-Teile $(a_{11}) + (a_{12}) + (a_{13}) = 100$,

30 Gew.-Teile $\leqq$ Gew.-Teile $(a_{11}) \leqq$ 70 Gew.-Teile,
5 Gew.-Teile $\leqq$ Gew.-Teile $(a_{12}) \leqq$ 50 Gew.-Teile
und

5 Gew.-Teile ≦ Gew.-Teile ($a_{13}$) ≦ 40 Gew.-Teile.

Ihre Darstellung kann z.B. nach der LDPE (= low density polyethylene)-Hochdruckpolymerisations-Methode bei Temperaturen von 200 bis 400 °C und einem Druck von mehr als 800 kg/$cm^2$ erfolgen [s. z.B. DE-B-23 41 462 und US-A-3 264 272].

Als Comonomere ($a_{13}$) geeignete Vinylester sind hierbei insbesondere solche der allgemeinen Formel III

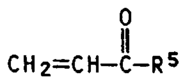 III,

worin $R^5$ einen Alkyl- oder Cycloalkylrest mit 1 bis 10 C-Atomen bedeutet, z.B. Vinylacetat, Vinylpropionat, Vinylbutyrat, Valeriansäurevinylester oder Hexancarbonsäurevinylester. Bevorzugt ist Vinylacetat.

Als Comonomere ($a_{13}$) geeignete Vinylether sind hierbei insbesondere solche der allgemeinen Formel IV

$CH_2 = CH\text{-}OR^5$ IV,

worin $R^5$ die oben angegebene Bedeutung hat, z.B. Vinylethylether, Vinyl-1-propylether, Vinyl-2-propvlether, Vinyl-1-butylether, Vinyl-2-butylether oder Vinyl-1-pentylether. Bevorzugt ist Vinyl-1-butylether.

Als Comonomere ($a_{13}$) geeignete Acrylsäureester, Methacrylsäureester, Acrylsäureamide und Methacrylsäureamide sind hierbei insbesondere solche der allgemeinen Formel V

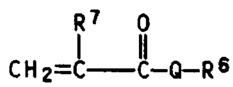 V,

worin $R^7$ eine Methylgruppe oder ein Wasserstoffatom bezeichnet und worin $R^6$ einen Alkyl- oder Cycloalkylrest mit 1 bis 10 C-Atomen oder einen ω-Methyl-poly(alkylenoxid)-α-oxyl-Rest darstellt und Q ein Sauerstoffatom oder eine $NR^8$-Gruppe mit $R^8$ = H oder $C_1$-$C_4$-Alkyl bezeichnet. Beispiele geeigneter Acrylsäureester, Methacrylsäureester, Acrylsäureamide und Methacrylsäureamide sind Methylacrylat, Methylmethacrylat, Ethylacrylat, Ethylmethacrylat, Propylacrylat, Propylmethacrylat, n-Butylacrylat, n-Butylmethacrylat, n-Pentylacrylat, n-Pentylmethacrylat, n-Hexylacrylat, n-Hexylmethacrylat, tert.-Butylacrylat, Cyclohexylacrylat, Cyclohexylmethacrylat, 2-Ethylhexylacrylat, 2-Ethylhexylmethacrylat, Dicyclopentandienylacrylat, ω-Methyl-poly(ethylenoxid)-α-yl-(meth)acrylat, ω-Methylpoly(propylen-1,2-oxid)-α-yl-(meth)acrylat, ω-Methyl-poly(propylen-1,3-oxid)-α-yl-(meth)acrylat, N-Methyl-N-butyl-methacrylamid oder N-Ethyl-N-(2-ethylhexyl)-acrylamid. Bevorzugt sind n-Butylacrylat, 2-Ethylhexylacrylat, ω-Methyl-poly(ethylenoxid)-α-yl-acrylat und Dicyclopentadienylacrylat, von denen wiederum die ersten drei besonders bevorzugt sind.

Beispiele ganz besonders bevorzugter Copolymerisate sind Ethylen/(Meth)-Acrylsäure-Copolymerisate, die n-Butylacrylat, 2-Ethylhexylacrylat und/oder ω-Methyl-poly(ethylenoxid)-α-yl-acrylat als Comonomere ($a_{13}$) einpolymerisiert enthalten.

Die Copolymerisate können außerdem photopolymerisierbare Reste ($a_3$) der allgemeinen Formel VI enthalten

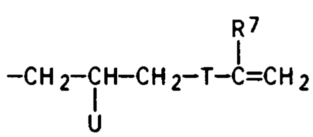 VI,

worin

- U eine Hydroxy-, eine Amino- oder eine Thiolgruppe,
- T eine Ester-, eine Amin-, eine Ether- oder eine $C_1$- bis $C_{10}$-Alkandiylgruppe und
- $R^7$ ein Wasserstoffatom oder eine Methylgruppe bezeichnet.

Beispiele geeigneter photopolymerisierbarer Reste ($a_3$) sind die

2-Hydroxy-5-oxo-4-oxahept-6-en-1-yl-,

2-Amino-5-oxo-4-oxahept-6-en-1-yl-, 2-Thiolo-5-oxo-4-oxahept-6-en-1-yl-, 2-Hydroxy-5-oxo-4-oxa-6-methylhept-6-en-1-yl-, 2-Amino-5-oxo-4-oxa-6-methylhept-6-en-1-yl-, 2-Hydroxy-5-oxo-4-azahept-6-en-1-yl-, 2-Amino-5-oxo-4-azahept-6-en-1-yl-, 2-Thiolo-5-oxo-5-azahept-6-en-1-yl-, 2-Hydroxy-5-oxo-4-aza-6-methylhept-6-en-1-yl-, 2-Hydroxy-5,10-dioxo-4,9-dioxa-6-aza-11-methyl-dodec-11-en-1-yl-, 2-Amino-5-oxo-4-aza-6-methyl-hept-6-en-1-yl-, 2-Thiolo-5-oxo-4-aza-6-methyl-hept-6-en-1-yl-, 2-Hydroxy-4-oxahex-5-en-1-yl-, 2-Amino-4-oxahex-5-en-1-yl-, 2-Thiolo-4-oxahex-5-en-1-yl-, 2-Hydroxy-hex-5-en-1-yl, 2-Amino-hex-5-en-1-yl-, 2-Thiolo-hex-5-en-1-yl-, 2-Hydroxy-hept-6-en-1-yl-, 2-Amino-hept-6-en-1-yl- oder 2-Thiolo-hept-6-en-1-yl-Reste. Bevorzugt ist der 2-Hydroxy-5-oxo-4-oxa-6-methyl-hept-6-en-1-yl-Rest VII.

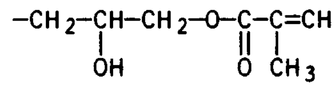 VII

Diese Reste ($a_3$) können auch in den übrigen Bindemitteln ($a_1$) vorhanden sein.

Außerdem können die Copolymerisate zusätzlich zu den photopolymerisierbaren Resten ($a_3$) oder anstelle von diesen seitenständige Reste der allgemeinen Formel VIII enthalten,

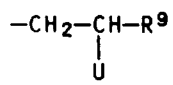 VIII,

worin $R^9$ eine polare Gruppe, ein Wasserstoffatom oder eine weitere Gruppe U bedeutet.

Unter polaren Gruppen werden solche Gruppen verstanden, welche zur Dipol-Dipol-, Dipol-Ion- oder Ion-Ion-Wechselwirkung befähigt sind.

Beispiele geeigneter Reste der allgemeinen Formel VIII sind 2-Hydroxy-eth-1-yl-, 2-Amino-eth-1-yl-, 2-Thiolo-eth-1-yl-. 2,3-Dihydroxi-prop-1-yl-, 2-Amino-3-hydroxy-prop-1-yl, 2-Thiolo-3-hydroxy-prop-1-yl- oder 2-Hydroxy-2-[$\omega$-alkyl-poly(ethylenoxid)-$\alpha$-yl]-eth-1-yl-Reste.

Sofern in den polymeren Bindemittel ($a_1$) photopolymerisierbare Reste ($a_3$) enthalten sind, liegt deren Menge bei 1 bis 60, vorzugsweise 1,5 bis 40, vorteilhafterweise 2 bis 30 und insbesondere 2 bis 15 Gew.% der lichtempfindlichen reliefbildenden Schicht (A). Gegebenenfalls kann dann auf die Zugabe von Monomeren ($a_3$) verzichtet werden.

Die lichtempfindliche reliefbildende Schicht (A) enthalt außerdem 0,001 bis 10, vorzugsweise 0,1 bis 7, vorteilhafterweise 0,2 bis 5 und insbesondere 0,3 bis 4 Gew.% eines oder mehrerer Initiatoren der Photopolymerisation (Photoinitiator) ($a_2$), wobei diese Menge mitbestimmt wird von der Menge an mitverwendeten Komponenten ($a_3$).

Beispiele geeigneter Photointiatoren ($a_2$) sind Benzoin oder Benzoinderivate, wie dessen Methyl-, Isopropyl-, n-Butyl- oder Isobutylether; symmetrisch oder unsymmetrisch substituierte Benzilacetale, wie Benzildimethylacetal, Benzil-1-methyl-1-ethyl-acetal; oder Acylarylphosphinoxide, wie 2-Dimethoxibenzoyl-diphenylphosphinoxid, 2,4,6-Trimethylbenzoyl-diphenylphosphinoxid, 2,4,6-Trimethylbenzoyl-phenylphosphinsäureethylester oder 2,4,6-Trimethylbenzoyl-phenylphosphinsäure-Natrium-Salz oder substituierte oder unsubstituierte Chinone, wie Ethylanthrachinon, Benzanthrachinon, Benzophenon oder 4,4'-Bis-(dimethylamino)benzophenon. Sie können allein oder im Gemisch miteinander oder in Verbindung mit Coinitiatoren verwendet werden, z.B. Ethylanthrachinon mit 4,4'-Bis-(dimethylamino)benzophenon, Benzoinmethylether mit Triphenylphosphin, Diacylphosphinoxide mit tertiären Aminen oder Acylarylphosphinoxide mit Benzildimethylacetal.

Außerdem enthält die lichtempfindliche reliefbildende Schicht (A) 1 bis 60, vorzugsweise 1,5 bis 40, vorteilhafterweise 2 bis 30 und insbesondere 2 bis 15 Gew.% einer oder mehrerer mit dem Bindemittel ($a_1$) verträglicher, photopolymerisierbare olefinisch ungesättigte Gruppen enthaltender Komponenten ($a_3$).

Sofern es sich bei diesen Komponenten ($a_3$) um photopolymerisierbare Reste ($a_3$) handelt, sei auf die Bindemittel ($a_1$) verwiesen.

Handelt es sich dagegen um Monomere ($a_3$), so besitzen diese im allgemeinen einen Siedepunkt von über 100 °C bei Atmosphärendruck und ein Molgewicht von bis zu 3000, insbesondere von bis zu 2000. Geeignet sind hierbei z.B. die Ester der Acrylsäure und/oder Methacrylsäure mit ein- oder mehrwertigen Alkoholen, wie Butylacrylat, Butylmethacrylat, 2-Ethylhexylacrylat, Lauryl(meth)acrylat, Ethylenglykol-di-(meth)acrylat, Butandiol-1,4-di(meth)acrylat, Neopentylglykol-di(meth)acrylat, 3-Methylpentandiol-di(meth)-acrylat, 2-Hydroxypropyl(meth)acrylat, 2-Hydroxyethyl(meth)acrylat, 1,6-Hexandiol-di(meth)acrylat, 1,1,1-Trimethylolpropan-tri(meth)acrylat, Di-, Tri- und Tetraethylenglykol-di(meth)acrylat, Tripropylenglykol-di(meth)-acrylat oder Pentaerythrit-tetra(meth)acrylat, Poly(ethylenoxid)-di(meth)acrylat, $\omega$-Methyl-poly(ethylenoxid)-$\alpha$-yl-(meth)acrylat, N,N-Diethylaminoethylacrylat oder ein Umsetzungsprodukt aus 1 Mol Glycerin, 1 Mol Epichlorhydrin und 3 Mol Acrylsäure; die Vinylester aliphatischer Monocarbonsäuren, wie Vinyloleat; die Vinylether von Alkoholen, wie Octadecylvinylether und Butandiol-1,4-divinylether; die Diester von Fumar- und Maleinsäure; oder die Umsetzungsprodukte aus OH-terminierten, oligomeren Polybutadienen mit Maleinsäure oder (Meth)Acrylsäure, d.h, oligomere Polybutadiene mit aktivierten, photopolymerisierbaren olefinischen Doppelbindungen.

Ferner kann die lichtempfindliche reliefbildende Schicht (A) einen oder mehrere Hilfsstoffe enthalten, mit deren Hilfe das anwendungstechnische Eigenschaftsprofil der Reliefschicht (A') variiert werden kann.

Hierbei handelt es sich vor allem um Weichmacher, Inhibitoren der thermisch initiierten Polymerisation, Farbstoffe, Pigmente, photochrome Zusätze, Mittel zur Verbesserung der Reliefstruktur, Vernetzungshilfsmittel, Antioxidanten, Antiozonantien, Füllstoffe, Flußmittel oder Formtrennmittel. Ihre Menge soll im allgemeinen 40 Gew.% der Schicht (A) nicht überschreiten.

Beispiele für Weichmacher sind modifizierte und unmodifizierte Naturöle und -harze, wie paraffinische oder naphthenische Öle sowie Erdölharze oder Pentaerythritolester von hydriertem Kollophonium; Alkyl-, Alkenyl-, Arylalkyl- oder Arylalkenylalkoholester von Säuren, wie Zitronensäure, Essigsäure. Propionsäure, Buttersäure, Ethylbuttersäure, Ethylhexansäure, Glykolsäure, Benzoesäure, Phthalsäure, Trimellitsäure, Abietinsäure, Phosphorsäure oder Stearinsäure; synthetische Oligomere oder Harze, wie Oligostyrol, oligomere Styrol-Butadien-Copolymerisate, Oligo-$\alpha$-methylstyrol, oligomere $\alpha$-Methylstyrol/p-Methylstyrol-Copolymerisate, flüssige 1,2- oder 1,4-Oligobutadiene, Oligopentadiene. flüssige oligomere Acrylnitril-Butadien-Copolymerisate sowie Polyterpen-, Polyacrylat-, Polyester- oder Polyurethanharze, synthetische Polymere, wie Polyethylen oder Ethylen-Propylen-Dien-Kautschuke; $\omega$-Methyl-oligo(ethylenoxid); oder Sulfonamide. Von Vorteil sind Mengen von 1 bis 25 Gew.%, bezogen auf die Schicht (A).

Inhibitoren der thermisch initiierten Polymerisation werden im allgemeinen in einer Menge von 0,001 bis 2 Gew.%, bezogen auf die Schicht (A), zugesetzt und weisen keine nennenswerte Eigenabsorption in dem aktinischen Bereich auf, in dem der Photoinitiator ($a_2$) absorbiert. Beispiele für Inhibitoren sind Hydrochinon, p-Methoxiphenol, 2,6-Di-tert.-butyl-p-kresol, $\beta$-Haphthol, Phenothiazin, Pyridin, Nitrobenzol, m-Dinitrobenzol oder Chloranil; Thiazinfarbstoffe, wie Thioninblau G (C. I. 52025), Methylenblau B (C.I. 52015) oder Toluidinblau (C.I. 52040); oder N-Nitrosamine, wie N-Nitrosodiphenylamin, oder die Salze, beispielsweise die Kalium, Calcium- oder Aluminiumsalze, des N-Nitrosocyclohexylhydroxylamins.

Farbstoffe, Pigmente oder photochrome Zusätze können den Gemischen in einer Menge von 0,0001 bis 2 Gew.%, bezogen auf die Schicht (A), zugesetzt werden. Sie dienen der Steuerung der Belichtungseigenschaften, der Identifizierung, der direkten Kontrolle des Belichtungsergebnisses oder ästhetischen Zwecken, Voraussetzung für die Auswahl und die Menge solcher Zusätze ist es, daß sie - ebenso wie die Inhibitoren der thermisch initiierten Polymerisation - die Photopolymerisation der Gemische nicht stören. Geeignet sind z.B. die löslichen Phenazinium-, Phenoxazinium-, Acridinium und Phenothiaziniumfarbstoffe. Diese Farbstoffe werden auch zusammen mit einer hinreichenden Menge eines Reduktionsmittels verwendet, welches den Farbstoff in Abwesenheit von aktinischem Licht nicht reduziert, bei Belichtung jedoch den Farbstoff im angeregten Elektronenzustand reduzieren kann. Beispiele solcher milden Reduktionsmittel sind Ascorbinsäure, Anethol, Thioharnstoff, z.B. Diethylallylthioharnstoff, insbesondere N-Allylthioharnstoff, sowie Hydroxylaminderivate, insbesondere Salze des N-Nitrosocyclohexylhydroxylamins, vorzugsweise die Kalium-, Calcium- und Aluminiumsalze. Letztere können, wie erwähnt, zugleich als Inhibitoren der thermisch initiierten Polymerisation dienen.

Die Reduktionsmittel werden im allgemeinen in Mengen von 0,005 bis 5 Gew.%, bezogen auf die Schicht (A) zugesetzt, wobei sich in vielen Fällen der Zusatz eines 3- bis 10fachen der Menge an mitverwendetem Farbstoff bewährt hat.

Beispiele für Vernetzungshilfsmittel sind die üblichen und bekannten tri- und tetrafunktionellen Thiolverbindungen.

Beispiele für Antioxidanten sind sterisch gehinderte Monophenole, wie 2,6-Di-tert.-butyl-p-kresol; alkylierte Thiobis- und Alkylidenbisphenole, wie 2,2'-Methylen-bis-(4-methyl-6-tert.-butylphenol) oder 2,2'-Bis-(1-hyxdroxy-4-methyl-6-tert.-butylphenyl)sulfid; Hydroxybenzyle, wie 1,3,5-Trimethyl-2,4,6-tris-(3,5-di-tert.-butyl-4-hydroxybenzyl)benzol; Triazine, wie 2-(4-Hydroxy-3,5-tert.-butylanilino)-4,6-bis-(n-octylthio)-1,3,5-triazin; polymerisiertes Trimethyldihydrochinon; Zinkbutyldithiocarbamat; Dilaurylthiodipropionat; oder Phosphite, wie Tris(nonylphenyl)-phosphit. Von Vorteil sind Mengen 0,0001 bis 5 Gew.%, bezogen auf die Schicht (A).

Beispiele für nicht molekulardispers einmischbare, polymere oder nicht polymere organische und anorganische Füllstoffe oder Verstärkungsfüllstoffe sind solche, die für die Wellenlängen des zur Belichtung der erfindungsgemäßen Gemische verwendeten Lichts im wesentlichen durchlässig sind, dieses nicht streuen und in ihrem Brechungsindex weitgehend dem betreffenden Gemisch angepaßt sind, wie etwa Polystyrol, organophiles Siliciumdioxid, Bentonit, Kieselsäure, ®Aerosil, organophiles Aluminiumoxid, Glaspulver, kolloidaler Kohlenstoff sowie verschiedene Arten von Farbstoffen und Pigmenten. Diese Hilfsstoffe werden in Mengen verwendet, die mit den gewünschten Eigenschaften der erfindungsgemäßen Aufzeichnungsmaterialien variieren. Die Füllstoffe haben den Vorteil, daß sie die Festigkeit der reliefbildenden Schicht (A) und der hieraus hergestellten Reliefschicht (A') sowie deren Abriebfestigkeit verbessern, deren Klebrigkeit verringern und unter Umständen hierin als farbgebende Mittel wirksam sind.

Ein Beispiel für ein Flußmittel ist Calciumstearat.

Ein Beispiel für ein Formtrennmittel ist Talkum.

Beispiele für Antiozonantien sind die üblichen und bekannten Ozonschutzwachse sowie die Chloralkane (Chlorparaffine) mit 8 bis 40 Kohlenstoffatomen und 30 bis 73 Gew.% Chlor im Molekül.

Beispiele für Mittel zur Verbesserung der Reliefstruktur der aus den erfindungsgemäßen Aufzeichnungsmaterialien hergestellten Druckplatten sind beispielsweise 9,9'-Dianthronyl und 10,10'-Bisanthron.

Lichtempfindliche reliefbildende Schichten (A), welche die vorstehend beschriebenen Komponenten ($a_1$), ($a_2$), ($a_3$) und ggf. ($a_4$) enthalten, sind nach der bildmäßigen Belichtung mit aktinischem Licht mit organischen, wäßrig-alkoholischen oder wäßrig-alkalischen Entwicklern zu entwickeln.

Die Dicke der Schichten (A) richtet sich in erster Linie nach dem Verwendungszweck der erfindungsgemäßen Aufzeichnungsmaterialien: So variiert die Dicke im allgemeinen von 0,001 bis 7, vorzugsweise 0,1 bis 7 und insbesondere 0,7 bis 6,5 mm, weil Aufzeichnungsmaterialien, welche Schichten (A) dieser Dicke aufweisen, für die Mehrzahl der Drucktechniken sowie für die Photoresisttechnik geeignet sind.

Ein weiterer wesentlicher Bestandteil des erfindungsgemäßen Aufzeichnungsmaterials ist die Deckfolie (C), welche sich von der Deckschicht (B) leicht ablösen läßt.

Die Deckfolien (C) sind im allgemeinen 10 bis 250, insbesondere 20 bis 150 µm dick. Sie bestehen im wesentlichen aus Kunststoffen, textilen Stoffen, Papieren oder Metallen. Diejenige Oberfläche der Deckfolien (C), welche der Deckschicht (B) unmittelbar aufliegt, ist entweder glatt, d.h., sie weist einen Oberflächenrauhwert $R_{max} \leqq 0,1$ µm auf, oder sie ist mattiert, d.h., sie hat einen Oberflächenrauhwert $R_{max}$ zwischen 0,1 und 15, vorzugsweise 0,3 bis 10, und insbesondere 0,5 bis 7 µm. Sofern die Deckfolie (C) mattiert ist, prägt sich ihr Rauhheitsmuster in die Deckschicht (B) und ggf. auch noch in die Oberfläche der reliefbildenden Schicht (A) ein. Diese glatte oder matte Oberfläche der Deckfolie (C) kann außerdem antihaftend ausgerüstet sein, d.h., sie kann beispielsweise eine 0,1 bis 0,5 µm dicke Antihaftschicht (AS) aus üblichen und bekannten Silikonen oder aus anderen Kunststoffen, wie etwa Polyethylen oder Polypropylen aufweisen. Deckschichten (C) aus textilen Stoffen oder Papieren können zudem mit Kunststoffen, wie Harnstoffformaldehyd oder Polyolefinen imprägniert sein. Deckschichten (C) aus Kunststoffen können überdies biaxial gereckt sein. Hierbei ist es oftmals von Vorteil, vor der biaxialen Reckung eine 0,1 bis 0,5 µm dicke Schicht aus beispielsweise einem Vinylidenchloridcopolymerisat auf derjenigen Seite von (C) aufzutragen, welche später (B) direkt aufliegt.

Beispiele besonders vorteilhafter Deckfolien (C) sind 20 bis 150 µm dicke, glatte oder mattierte, biaxial gereckte oder ungereckte, ggf. antihaftend ausgerüstete Kunststoffolien aus Polyethylen, Polypropylen, Polyamid, Polystyrol, Styrol/Acrylnitril-Copolymerisaten oder aus Polymethylmethacrylat; oder aus Copolymerisaten von Methylmethacrylat mit Methacrylsäure, Acrylsäure, Methylacrylat oder mit Butylacrylat; oder aus Polyvinylchlorid, Polyvinylacetat, Vinylchlorid/Vinylacetat-Copolymerisaten, Polyvinylalkohol, Polyvinylpyrrolidon, Polycarbonat, Celluloseester, wie etwa Celluloseacetatsuccinat, oder aus Polyethylenterephthalat, von denen Deckfolien (C) aus Polyethylenterephthalat ganz besonders vorteilhaft sind.

Neben diesen wesentlichen Bestandteilen (A), (B) und (C) können die erfindungsgemäßen Aufzeichnungsmaterialien weitere Schichten aufweisen, welche für die Funktion der Aufzeichnungsmaterialien nützlich sind.

So kann die lichtempfindliche reliefbildende Schicht (A) mit einem dimensionsstabilen Träger (TR) haftfest oder leicht ablösbar verbunden sein. Der dimensionsstabile Träger (TR) wiederum kann mit einer weichelastischen Unterschicht (US) unterlegt sein. Ferner kann eine haftfeste Verbindung zwischen (TR)

und (A) mit Hilfe einer Haftschicht (HS) erreicht werden.

Als dimensionsstabile Träger (TR) können Platten, Folien oder konische oder zylindrische Röhren (sleeves) aus Metallen, wie Stahl, Aluminium, Kupfer oder Nickel oder aus Kunststoffen, wie Polyethylenterephthalat, Polybutylenterephthalat, Polyamid oder Polycarbonat verwendet werden. Daneben kommen noch Gewebe und Vliesse, z.B. Glasfasergewebe oder Verbundmaterialien aus z.B. Glasfasern und Kunststoffen wie Polyethylenterephthalat in Frage. Daneben kommen als Träger (TR) auch Platten in Betracht, wie sie üblicherweise bei der Herstellung von Leiterplatten verwendet werden.

Als Haftschichten (HS) werden mit Vorteil übliche und bekannte, etwa 0,5 bis 40 µm dicke Haftlackschichten verwendet.

Werden als Schichtträger (TR) stark reflektierende Platten oder Folien verwendet, dann können sie geeignete Lichthofschutzmittel, wie Ruß oder Mangandioxid enthalten. Die Lichthofschutzmittel können aber auch als separate Schicht auf (TR) aufgetragen werden oder in der Haftschicht (HS) oder in der reliefbildenden Schicht (A) enthalten sein.

Die Herstellung der wesentlichen Bestandteile (A), (B) und (C) des erfindungsgemäßen Aufzeichnungsmaterials weist keine technischen Besonderheiten auf, sondern erfolgt nach den üblichen und bekannten Methoden der Herstellung lichtempfindlicher Schichten und Deckschichten sowie nach den üblichen und bekannten Methoden der Herstellung von Folien aus Kunststoffen, textilen Stoffen, Papieren oder Metallen.

So werden die lichtempfindlichen reliefbildenden Schichten (A) und die Deckschichten (B) üblicherweise durch das Mischen der betreffenden Komponenten mittels der üblichen Knet-, Misch- und Lösungstechniken, gefolgt von dem Formen der Mischungen zu flächenförmigen Schichten mittels Gießen aus Lösung, Heißpressen, Kalandrieren oder Extrudieren, hergestellt. Üblicherweise sind diese Arbeitsgänge in das Verfahren zur Herstellung der erfindungsgemäßen Aufzeichnungsmaterialien integriert.

Die Bestandteile der besonders vorteilhaften Deckfolien (C) werden gleichfalls mittels der üblichen Knet-, Misch- und Lösungstechniken vermengt und durch Gießen aus Lösung, Heißpressen, Kalandrieren oder Extrudieren und Blasformen zu den entsprechenden Folien geformt. Auch diese Arbeitsgänge können in das Verfahren zur Herstellung der erfindungsgemäßen Aufzeichnungsmaterialien integriert sein, üblicherweise werden indes die Deckfolien (C) separat hergestellt, auf Rollen aufgewickelt und in dieser Form für die Herstellung der erfindungsgemäßen Aufzeichnungsmaterialien angewendet.

Auch die Herstellung der erfindungsgemäßen Aufzeichnungsmaterialien weist keine technischen Besonderheiten auf, sondern erfolgt in üblicher Weise durch Verbinden der reliefbildenden Schicht (A) mit der Deckschicht (B) und der Deckfolie (C), wobei dies auch auf einem dimensionsstabilen Träger (TR) ggf. unter Mitverwendung einer Haftschicht (HS) und einer weichelastischen Unterschicht (US) erfolgen kann. Hierbei ist es grundsätzlich möglich, die reliefbildende Schicht (A) zuerst mit dem Träger (TR) zu verbinden und anschließend ihre unbedeckte Seite mit der Deckschicht (B) und der Deckfolie (C) zu bedecken, oder aber die reliefbildende Schicht (A) wird zunächst auf die mit der Deckschicht (B) überzogene Deckfolie (C) aufgetragen und dann erst mit dem Träger (TR) verbunden. Selbstverständlich können diese Arbeitsgänge in üblichen und bekannten, kontinuierlich oder diskontinuierlich arbeitenden Anlagen hintereinander oder gleichzeitig ausgeführt werden.

Die erfindungsgemäßen Aufzeichnungsmaterialien dienen der Herstellung photopolymerisierter Hochdruck-, Tiefdruck-, Flexodruck- und Reliefplatten sowie Photoresists. Insbesondere eignen sie sich für die Herstellung von photopolymerisierten Hochdruck-, Tiefdruck- und Flexodruckplatten.

Die Herstellung der photopolymerisierten Druckplatten, Reliefplatten und Photoresists aus den erfindungsgemäßen Aufzeichnungsmaterialein umfaßt die folgenden Arbeitsgänge:

(1) ggf. Vorbehandeln der erfindungsgemäßen Aufzeichnungsmaterialien,

(2) Abziehen der Deckfolie (C) von der Deckschicht (B),

(3) Auflegen einer Bildmaske oder Negativvorlage auf die Deckschicht (B),

(4) bildmäßiges Belichten der lichtempfindlichen reliefbildenden Schicht (A) mit aktinischem Licht einer Wellenlänge $\lambda$ zwischen 230 und 450, insbesondere 350 und 450 nm,

(5) Auswaschen (Entwickeln) der unbelichteten Bereiche der bildmäßig belichteten reliefbildenden Schicht (A) mittels organischer, wäßrig-alkoholischer oder wäßrig alkalischer flüssiger Medien (Entwickler), wobei auch die Deckschicht (B) weggewaschen wird, und

(6) Trocknen sowie

(7) ggf. Nachbehandeln der in dieser Weise erhaltenen photopolymerisierten Druckplatten, Reliefplatten und Photoresists, welche nun eine Reliefschicht (A') enthalten oder aus dieser bestehen.

Die Dicke der Reliefschicht (A') variiert je nach Anwendungszweck der photopolymerisierten Druckplatten, Reliefplatten und Photoresists von 0,001 bis 7, vorzugsweise 0,1 bis 7 und insbesondere 0,7 bis 6,5 mm.

Eine übliche Methode der Vorbehandlung ist die vollflächige Belichtung der reliefbildenden Schicht (A) von ihrer Rückseite her mit aktinischem Licht. Unter Rückseite ist hierbei die Seite zu verstehen, welche dem später gebildeten Relief abgewandt ist.

Geeignete Lichtquellen für aktinisches Licht sind handelsübliche UV-Fluoreszenzröhren, Quecksilbermittel-, -hoch- und niederdruckstrahler, superaktinische Leuchtstoffröhren, Xenon-Impulslampen, mit Metalliodiden dotierten Lampen oder Kohlebogenlampen.

Beispiele geeigneter organischer Entwickler sind aliphatische oder aromatische Kohlenwasserstoffe, wie n-Hexan, n-Heptan, Octan, Petrolether, Ligroin, Limonen oder andere Terpene, Toluol, Xylol, Ethylbenzol oder Isopropylbenzol oder Gemische aus diesen Lösungsmitteln; Ketone, wie Aceton oder Methylethylketon; Ether, wie Di-n-butylether; Ester, wie Essigsäureethylester oder Acetessigsäureethylester; halogenierte aliphatische Kohlenwasserstoffe, wie Methylenchlorid, Chloroform, Trichlorethane, Tetrachlorethylen, Dichlortetrafluorethane oder Trichlortrifluorethane; oder Gemische, die zwei oder mehr dieser Lösungsmittel enthalten; oder Gemische, die eines oder mehrere dieser Lösungsmittel und zusätzlich noch Alkohole, wie Methanol, Ethanol, Isopropanol oder n-Butanol enthalten; oder Lösungsmittel und Gemische der genannten Art, die zusätzlich feste, flüssige oder gasförmige organische und anorganische Verbindungen, wie etwa Tenside, in untergeordenten Mengen enthalten.

Beispiele geeigneter wäßrig-alkoholischer Entwickler sind wäßrige Lösungen von Methanol, Ethanol, Isopropanol oder n-Butanol, welche zusätzlich noch feste flüssige oder gasförmige organische und anorganische Verbindungen, wie etwa Tenside, Komplexbildner, Salze, Alkalilaugen, Ammoniak oder Amine, in untergeordneten Mengen enthalten können.

Beispiele geeigneter wäßrig-alkalischer Entwickler sind wäßrige Lösungen von Lithium-, Natrium- oder Kaliumhydroxid oder von Lithium-, Natrium oder Kaliumcarbonat oder -hydrogencarbonat oder von Ammoniak, welche zusätzlich noch feste, flüssige oder gasförmige organische und anorganische Verbindungen, wie etwa Tenside, Komplexbildner oder Salze, in untergeordneten Mengen enthalten können.

übliche Methoden der Nachbehandlung der Reliefschicht (A') sind das vollflächige Nachbelichten mit aktinischem Licht einer Wellenlänge $\lambda$ zwischen 150 und 450 nm, das Nachbelichten mit sichtbarem Licht oder das Behandeln mit halogenhaltigen Lösungen.

Die in dieser Weise erhaltenen Hochdruck-, Tiefdruck- und Flexodruckplatten können auf Druckzylinder aufgebracht und für den Endlosdruck verwendet werden.

Die in dieser Weise hergestellten Photoresists können beispielsweise für die Herstellung von Leiterplatten verwendet werden.

Die neue erfindungsgemäß zu verwendende Deckschicht (B) weist zahlreiche besondere Vorteile auf, welche im Hinblick auf ihren hohen Gehalt an Zusatzstoffen in dieser Fülle nicht erwartbar waren:
Abgesehen davon, daß die neue Deckschicht (B) nach wie vor mit genauer Dickenkonstanz in einfacher Weise hergestellt werden kann, reißfest, lichtdurchlässig, hart, nicht klebrig, sauerstoffundurchlässig und in den Entwicklern leicht löslich oder quellbar ist, die Ablösung der Deckfolie (C) erleichtert und die Kontaktierung mit der Bildmaske oder Negativvorlage verbessert,

- neigen die in ihr enthaltenen Amine und Amide ($b_1$) und die Ammoniumsalze ($b_2$) nicht zur Migration, so daß sie eine vorzügliche Langzeitstabilität aufweist,
- verhindert sie die elektrostatische Aufladung der erfindungsgemäßen Aufzeichnungsmaterialien und die Ablagerung von Schmutzpartikeln und
- verbessert sie die kopiertechnischen Eigenschaften der erfindungsgemäßen Aufzeichnungsmaterialien, so daß sie
- die Herstellung von hochwertigen und besonders detailgetreuen photopolymerisierten Hochdruck-, Tiefdruck-, Flexodruck- und Reliefplatten sowie von Photoresists erheblich erleichtert oder gar erst möglich macht.

Die erfindungsgemäßen Aufzeichnungsmaterialien, welche die neue Deckschicht (B) enthalten, weisen gleichfalls zahlreiche unerwartete Vorteile auf. So sind sie in einfacher Weise exakt reproduzierbar herzustellen, sie laden sich beim Abziehen ihrer Deckfolie (C) nicht elektrostatisch auf, sie verfügen über hervorragende kopiertechnische Eigenschaften, wobei ihr großer Belichtungsspielraum hervorzuheben ist, sie weisen eine hervorragende Auflösung auf, so daß allerfeinste Bildelemente auch in der Form von Zwischentiefen detailgetreu wiedergegeben werden und sie neigen nicht zum "Zupolymerisieren" und zu der gefürchteten "inneren Zurichtung".

Weitere besondere Vorteile der erfindungsgemäßen Aufzeichnungsmaterialien werden insbesondere an den hieraus hergestellten photopolymerisierten Hochdruck-, Tiefdruck- und Flexodruckplatten offenbar. Deren Reliefschicht (A') weist keinen Polymerisationsgradienten und keine durch Unterstrahlung hervorgerufenen Unterschneidungen von Reliefteilen auf. Auch die allerfeinsten Bildelemente "stehen" völlig einwandfrei neben gröberen Elementen. Hierbei ist insbesondere die saubere Ausbildung der Zwischentiefen

hervorzuheben. Insgesamt wird das Original der Bildmaske oder Negativvorlage völlig detailgetreu durch die Reliefschicht (A') wiedergegeben, so daß die betreffenden Druckplatten hochwertige Produkte sind, die höchsten Qualitätsansprüchen genügen oder diese sogar übertreffen. Beim Drucken im Endlosdruck zeigen die Druckplatten vorzügliche Farbübertragungseigenschaften und neigen nicht zu Kantenausbrüchen und zu einem Ablösen von Reliefteilen aufgrund ungenügender Reliefversockelung, so daß sie eine besonders hohe Lebensdauer aufweisen, welche hohe Auflagen exzellenter Druckerzeugnisse ermöglicht. Hierbei ist besonders zu betonen, daß gerade photopolymerisierte Tiefdruckplatten, welche man aus den erfindungsgemäßen Aufzeichnungsmaterialien hergestellt hat, kratzerfrei drucken.

Beispiele und Vergleichsversuche

In den folgenden Beispielen und Vergleichsversuchen diente die bei gleichförmiger Beanspruchung der Aufzeichnungsmaterialien erzeugte elektrische Feldstärke in Zusammenhang mit der Relaxationszeit $t_{50}$, bei welcher die elektrische Feldstärke 50% des ursprünglichen Wertes erreicht, als Maß für die elektrostatische Aufladbarkeit der Aufzeichnungsmaterialien.

Zur Messung der Relaxationszeit $t_{50}$ wurde die Deckfolie (C) der Aufzeichnungsmaterialien unter exakt vergleichbaren Bedingungen maschinell von den betreffenden Deckschichten (B) (erfindungsgemäße Beispiele 1 bis 4) oder den betreffenden bekannten Deckschichten (Vergleichsversuche 1 bis 4) abgezogen, wonach man die hierbei resultierende elektrische Feldstärke (kV/m) und ihre Abnahme mit der Zeit induktiv mittels eines Elektrostatometers berührungslos maß. Je rascher diese Abnahme erfolgt, desto vorteilhafter ist das betreffende Aufzeichnungsmaterial.

Für die bildmäßige Belichtung der lichtempfindlichen Aufzeichnungsmaterialien verwendete man die üblichen und bekannten gerasterten oder ungerasterten Bildmasken oder Negativvorlagen sowie die gängigen Belichtungsapparaturen.

Für die Entwicklung der belichteten Aufzeichnungsmaterialien verwendete man handelsübliche Sprühwascher.

Als Nachbehandlungsbad diente eine 0,4%-ige wäßrige, tensidhaltige Bromlösung.

Die Aufzeichnungsmaterialien wurden in üblicher und bekannter Weise durch Extrusion der Komponenten der reliefbildenden Schichten (A) auf einem Zweischneckenextruder, Austragen der Gemische aus einer Breitschlitzdüse und durch Verbinden der resultierenden lichtempfindlichen reliefbildenden Schichten (A) mit dimensionsstabilen Trägern (TR) und Deckfolien (C), welche auf der den reliefbildenden Schichten (A) zugewandten Seite Deckschichten (B) oder bekannte Deckschichten aufwiesen, mittels Kalandrieren hergestellt. Vor der Weiterverarbeitung wurden die Aufzeichnungsmaterialien in üblicher Weise getrocknet und eine Woche gelagert.

Die Herstellung der neuen und der bekannten Deckschichten auf den Deckfolien (C) erfolgte durch Gießen aus Lösungen.

Die Herstellung und Weiterverarbeitung der Aufzeichnungsmaterialien wurde in ungereinigter Luft durchgeführt.

Die Qualität der Reliefschichten wurde visuell unter einem Mikroskop begutachtet und wie folgt benotet:

- ausgezeichnet (fehlerfreies Relief, alle Bildelemente sind völlig einwandfrei wiedergegeben, es treten keine Unterschneidungen der Reliefflanken oder Kantenausbrüche auf, Kratzer sind nicht vorhanden)
- gut (weitgehend fehlerfreies Relief, es treten keine Unterschneidungen der Reliefflanken oder Kantenausbrüche auf, die feinsten Bildelemente "stehen" zwar, allerdings nicht in optimaler Qualität, wenige Kratzer sind vorhanden)
- mäßig (stellenweise fehlerhaftes Relief, nicht alle feinsten Bildelemente sind detailgetreu, sondern mit gewisser Verzerrung wiedergegeben, Unterschneidungen der Reliefflanken oder Kantenausbrüche sind vermehrt zu beobachten, eine erhöhte Anzahl von Kratzern tritt auf).

Die Druckversuche wurden auf gängigen Hoch-, Tief- oder Flexodruckwerken ausgeführt, wobei die für die entsprechenden Drucktechniken üblichen Druckfarben verwendet wurden. Maß für die Druckqualität war die erreichbare Auflage an exzellenten Drucken.

Beispiele 1 bis 4 und Vergleichsversuche 1 bis 4

Versuchsvorschrift:

Für die Beispiele und die Vergleichsversuche wurden zunächst vier lichtempfindliche Gemische hergestellt, so wie sie für lichtempfindliche reliefbildende Schichten (A) in Flexodruckplatten (Beispiele 1a, 1b, 2a und 2b; Vergleichsversuche 1-Va, 1-Vb, 1-Vc, 2-Va, 2-Vb und 2-Vc), Hochdruckplatten (Beispiele 3a und 3b; Vergleichsversuche 3-Va, 3-Vb, 3-Vc) und Tiefdruckplatten (Beispiele 4a und 4b; Vergleichsversuche 4-Va, 4-Vb und 4-Vc) typischerweise verwendet werden.

Diese Gemische wurden auf Trägern (TR) zu lichtempfindlichen reliefbildenden Schichten (A) geformt. Als Träger (T) wurden 125 $\mu$m dicke Polyethylenterephthalatfolien verwendet, welche auf der der reliefbildenden Schicht (A) zugewandten Seite eine 0,5 $\mu$m dicke Polyurethan-Haftlackschicht aufwiesen. Die Dicke der jeweiligen reliefbildenden Schicht (A) richtete sich in erster Linie nach dem Verwendungszweck und lag im Falle der Flexodruckplatten bei

- 3 mm (Beispiele 1a, 1b, 2a und 2b; Vergleichsversuche 1-Va, 1-Vb, 1-Vc, 2-Va, 2-Vb und 2-Vc),

im Falle der Hochdruckplatten bei

- 0,8 mm (Beispiele 3a und 3b; vergleichsversuche 3-Va, 3-Vb und 3-Vc)

und im Falle der Tiefdruckplatten bei

- 0,2 mm (Beispiele 4a und 4b; Vergleichsversuche 4-Va, 4-Vb und 4-Vc).

Die reliefbildenden Schichten (A) wurden mit den neuen Deckschichten (B) (Beispiele) oder mit bekannten Deckschichten (Vergleichsversuche) und mit 125 $\mu$m dicken, einseitig mattierten ($R_{max}$ = 5 $\mu$m) Polyethylenterephthalatfolien (C) abgedeckt.

Die Tabelle 1 gibt eine Übersicht über die stoffliche Zusammensetzung der reliefbildenden Schichten (A), der Deckschichten (B) und der bekannten Deckschichten.

Nach der Herstellung dieser erfindungsgemäßen und bekannten Aufzeichnungsmaterialien wurde ihre elektrostatische Aufladbarkeit an den Aufzeichnungsmaterialien entnommenen Proben separat bestimmt.

Die Ergebnisse dieser Messungen sind in Tabelle 2 zusammengefaßt.

Desweiteren wurden die Aufzeichnungsmaterialien nach dem Abziehen der Deckfolien (C) bildmäßig belichtet, entwickelt, getrocknet, im Falle der photopolymerisierten Flexodruckplatten der Beispiele 1a und 1b sowie der Vergleichsversuche 1-Va bis 1-Vc nachbehandelt und erneut getrocknet, auf Druckzylinder aufgespannt und für den Endlosdruck verwendet.

Hierbei erfolgte die Entwicklung von Druckplatten

- aus den Beispielen 1a und b und den Vergleichsversuchen 1-Va bis 1-Vc mittels organischer Entwickler (Tetrachlorethylen/n-Butanol; Volumenverhältnis 4:1),
- aus den Beispielen 2a und b und den Vergleichsversuchen 2-Va bis 2Vc mittels wäßrig-alkalischer Entwickler (0,5%ige Natronlauge)
  und
- aus den übrigen Beispielen und Vergleichsversuchen mittels wäßrigalkoholischer Entwickler (Wasser/Ethanol; Volumenverhältnis 18:82).

Die Ergebnisse der visuellen Beurteilung der Qualität der Reliefschichten (A') und die Ergebnisse der Druckversuche finden sich gleichfalls in der Tabelle 2.

Der Vergleich all dieser Versuchsergebnisse zeigt, daß die erfindungsgemäßen Aufzeichnungsmaterialien eine erheblich geringere elektrostatische Aufladbarkeit aufweisen als die bekannten Aufzeichnungsmaterialien und daß sie bessere photopolymerisierte Druckplatten und höhere Auflagen an exzellenten Drucken liefern als die bekannten Aufzeichnungsmaterialien.

In der Tabelle 1 weisen die verwendeten Abkürzungen und die in Anführungszeichen gesetzten Kurzbezeichnungen die folgende Bedeutung auf:

| | |
|---|---|
| "Blockcopolymerisat": | Ein Blockcopolymerisat Y-X-X' (Viskositätszahl VZ = 164,9 ml/g; mittlere Molmasse $M_w$ = $1{,}9.10^5$) der Zusammensetzung: 10 Gew.% Polystyrol (Y-Block); 80 Gew.% Polyisopren (X-Block, Glastemperatur Tg = -35 °C); 10 Gew.% Polyisopren mit einem Gehalt von 53% an 3,4-Strukturen und einem Gehalt an einpolymerisiertem Styrol von 40 Gew.% (X'-Block, Glastemperatur Tg = + 10 °C); |
| $HDA_2$: | 1,6-Hexandioldiacrylat; |
| "Initiator I": | Benzildimethylacetal; |
| "Chloralkan": | Chlorparaffin eines Chlorgehalts von 49% und einer Dichte von 1,24 g/cm$^3$; |
| "Oligomer": | Oligomer aus 70 Gew.% p-Methylstyrol und 30 Gew.% $\alpha$-Methylstyrol; |
| EPM: | EPM-Kautschuk aus 60 Gew.% Ethylen und 40 Gew.% Propylen; |

| | |
|---|---|
| "Polymerisat": | Copolymerisat, welches durch Copolymerisation einer Mischung aus 56,6 Gew.% Ethylen, 14,9 Gew.% Acrylsäure 11 Gew.% ω-Methyl-poly-(ethylenoxid)-α-yl-acrylat und 17,5 Gew.% 2-Ethylhexylacrylat hergestellt wurde und 1 Gew.% an 2-Hydroxy-5-oxo-4-oxa-6-methyl-hept-6-en-1-yl-Resten (photopolymerisierbarer Rest $a_3$) enthielt; |
| $TEGA_2$: | Tetraethylenglykoldiacrylat; |
| "Initiator II": | 2,4,6-Trimethylbenzoyldiphenylphosphinoxid; |
| "Calciumsalz": | Calciumsalz des N-Nitrosocyclohexylhydroxylamins; |
| PVA: | handelsüblicher Polyvinylalkohol (Polyvinylacetat eines Hydrolysegrades von 95%); |
| "Polyamid I" oder PA I: | handelsübliches Polyamid der BASF AG, ®Ultramid-1C; |
| "Polyamid II" oder PA II: | handelsübliches Polyamid der Henkel AG, ®Macromelt; |
| $HDMA_2$: | 1,6-Hexandioldimethacrylat; |
| TMPTMA: | Trimethylolpropantrimethacrylat; |
| "Kaliumsalz": | Kaliumsalz des N-Nitrosocyclohexylhydroxylamins; |
| HEMA: | 2-Hydroxyethylmethacrylat; |
| $SiO_2$: | handelsübliche pyrogene Kieselsaure, ®Aerosil; |
| "Amin ($b_{11}$)": | N,N-Bis-(2-hydroxyethyl)-N-stearyl-amin; |
| "Amin ($b_{12}$)": | N,N-Bis-(2-hydroxyethyl)-laurinsäureamid, N,N-Bis-(2-hydroxyethyl)-palmitinsäureamid und N,N-Bis-2-hydroxyethyl)-ölsäureamid (Gewichtsverhältnis, 1:3:1,1); |
| "Amin ($b_{13}$)": | N,N-Bis-(2-hydroxyethyl)-N-palmitylamin und N,N-Bis-(2-hydroxyethyl)-N-oleylamin (Gewichtsverhältnis, 10:1); |
| "Ammoniumsalz ($b_{21}$)": | N-Methyl-N,N-bis-(2-hydroxyethyl)-N-stearylammonium-ethylsulfat; |
| "Ammoniumsalz ($b_{22}$)": | N,N-Dimethyl-N-(2-hydroxyethyl)-N-(3-stearylamidopropyl)-ammonium-ethylsulfat; |
| "Ammoniumsalz ($b_{23}$)": | N-Methyl-N,N-bis-(2-hydroxyethyl)-N-(3-lauryloxi-2-hydroxypropyl)-ammonium-ethylsulfat, N-Methyl-N,N-bis-(2-hydroxyethyl)-N-(3-myristyloxi-2-hydroxypropyl)-ammonium-ethylsulfat und N,N,N-trimethyl-N-(2-hydroxyethyl)-ammonium-ethylsulfat (Gewichtsverhältnis 10:2:0,5); |

Tabelle 1: Beispiele 1 bis 4 und Vergleichsversuche 1V bis 4V; die stoffliche Zusammensetzung erfindungsgemäßer und bekannter Aufzeichnungsmaterialien

| Bsp. Nr. | Zusammensetzung der lichtempfindlichen reliefbildenden Schicht (A) | Zusammensetzung der Deckschicht (B) a | b | Va | Vb | Vc |
|---|---|---|---|---|---|---|
| 1 | 80,917 Gew.% "Blockcopolymerisat" | EPM | EPM | EPM | EPM | EPM |
| | 7,268 Gew.% $HDA_2$ | (90 Gew.%) | (97 Gew.%) | (100 Gew.%) | (95 Gew.%) | (97,99 Gew.%) |
| | 1,350 Gew.% "Initiator I" | "Amin($b_{11}$)" | "Ammonium-salz($b_{21}$)" | | ethoxylierter Phosphorsäure-oleylester | $HDA_2$ |
| | 5.000 Gew.% "Chloralkan" | (10 Gew.%) | (3 Gew.%) | | (5 Gew.%) | (2 Gew.%) |
| | 5,000 Gew.% "Oligomer" | | | | | "InitiatorI" |
| | 0,457 Gew.% 2,6-Di-tert.-butyl-p-kresol | | | | | (0,01 Gew.%) |
| | 0,008 Gew.% Solvent Black 3(C.I.26150) | | | | | |

Tabelle 1 (Fortsetzung)

| Bsp. Nr. | Zusammensetzung der lichtempfindlichen reliefbildenden Schicht (A) | | | Zusammensetzung der Deckschicht (B) | | | | |
|---|---|---|---|---|---|---|---|---|
| | | | | a | b | Va | Vb | Vc |
| 2 | 92,123 | Gew.% | "Polymerisat" | PVA | PVA | PVA | PVA | PVA |
| | 5,070 | Gew.% | $TEGA_2$ | (95 Gew.%) | (96 Gew.%) | (100 Gew.%) | (90 Gew.%) | (98 Gew.%) |
| | 0,506 | Gew.% | "Initiator II" | "Amin ($b_{12}$)" | "Ammoniumsalz ($b_{22}$)" | | ethoxylierter Phosphorsäureoleylester | Isooctyl-phenyl-poly-ethoxi-ethanol mit 9 bis 10 Ethoxigruppen |
| | 0,920 | Gew.% | 2,6-Di-tert.-butyl-p-kresol | (5 Gew.%) | (4 Gew.%) | | | |
| | 0,414 | Gew.% | "Calciumsalz" | | | | (10 Gew.%) | |
| | 0,046 | Gew.% | Safranin T (C.I. 50240) | | | | | (2 Gew.%) |
| | 0,921 | Gew.% | MgO | | | | | |
| 3 | 71 | Gew.% | "Polyamid I" | "PA II" | "PA II" | "PA II" | "PA II" | "PA II" |
| | 15 | Gew.% | $HDMA_2$ | (85 Gew.%) | (90 Gew.%) | (100 Gew.%) | (95 Gew.%) | (96,99 Gew.%) |
| | 6 | Gew.% | TMPTMA | "Amin ($b_{13}$) | "Ammoniumsalz ($b_{23}$)" | | ethoxylierter Phosphorsäureoleylester | $HDMA_2$ |
| | 2,095 | Gew.% | "Initiator I" | (15 Gew.%) | (10 Gew.%) | | | (3 Gew.%) |
| | 5 | Gew.% | N-Ethyltoluolsulfonamid | | | | (5 Gew.%) | "InitiatorI" |
| | 0,9 | Gew.% | "Kaliumsalz" | | | | | (0,01 Gew.%) |
| | 0,005 | Gew.% | Safranin T (C.I. 50240) | | | | | |

Tabelle 1 (Fortsetzung)

| Bsp. Nr. | Zusammensetzung der lichtempfindlichen reliefbildenden Schicht (A) | | Zusammensetzung der Deckschicht (B) a | b | Va | Vb | Vc |
|---|---|---|---|---|---|---|---|
| 4 | 50 Gew.% | "Polyamid I" | "PA I" | "PA I" | "PA I" | "PA I" | "PA I" |
| | 40 Gew.% | HEMA | (95 Gew.%) | (98 Gew.%) | (100 Gew.%) | (95 Gew.%) | (96 Gew.%) |
| | 2 Gew.% | "Initiator II" | "Amin ($b_{11}$)" | "Ammonium-salz ($b_{21}$)" | | ethoxylier-ter Phos-phorsäure-oleylester | HEMA |
| | 0,9 Gew.% | "Kaliumsalz" | (5 Gew.%) | (2 Gew.%) | | | (3,99 Gew.%) |
| | 0,05 Gew.% | Safranin I (C.I. 50240) | | | | (5 Gew.%) | "InitiatorII" |
| | 7,05 Gew.% | "$SiO_2$" | | | | | (0,01 Gew.%) |

Tabelle 2: Elektrostatische Aufladbarkeit der Aufzeichnungsmterialien aus der Tabelle 1 und die relevanten anwendungstechnischen Eigenschaften der hieraus hergestellten photopolymerisierten Druckplatten

| Beispiel Nr. | Feldstärke (kV/m) | $t_{50}$ (min) | Qualität der Reliefschicht (A') Note | erreichbare Auflage an exzellenten Drucken im Endlosdruck | Bemerkungen |
|---|---|---|---|---|---|
| 1a | 2 | < 0,03 | ausgezeichnet | > $5.10^4$ ) | |
| 1b | 5 | < 0,02 | ausgezeichnet | > $5.10^4$ ) | die |
| 2a | 2,5 | < 0,01 | ausgezeichnet | > $5.10^4$ ) | Druckversuche |
| 2b | 3 | ≤ 0,02 | ausgezeichnet | > $5.10^4$ ) | wurden jeweils |
| 3a | 10 | < 0,01 | ausgezeichnet | > $6.10^5$ ) | bei dieser |
| 3b | 7 | < 0,02 | ausgezeichnet | > $6.10^5$ ) | Auflage abgebrochen, weil |
| 4a | 14 | < 0,04 | ausgezeichnet | > $10^6$ ) | kein Qualitätsverlust |
| 4b | 11 | < 0,02 | ausgezeichnet | > $10^6$ ) | sichtbar war |
| Vergleichsversuche | | | | | |
| 1-Va | 20 | 0,1 | gut | ab $3.10^3$ | allmählicher Qualitätsverlust |
| 1-Vb | 12 | 0,2 | gut | ab $2,5.10^3$ | allmählicher Qualitätsverlust |
| 1-Vc | 25 | 0,1 | mäßig | keine exzellenten Drucke erhältlich | |
| 2-Va | 8 | 2 | gut | ab $10^4$ | allmählicher Qualitätsverlust |
| 2-Vb | 5 | 0,4 | gut | ab $10^4$ | rascher Qualitätsverlust |
| 2-Vc | 7 | 0,8 | gut | ab $2.10^4$ | allmählicher Qualitätsverlust |
| 3-Va | 20 | 15 | gut | ab $3.10^5$ | allmählicher Qualitätsverlust |
| 3-Vb | 11 | 10 | mäßig | keine exzellenten Drucke erhältlich | |
| 3-Vc | 22 | 25 | mäßig | keine exzellenten Drucke erhältlich | |
| 4-Va | 11 | 5 | gut | ab $4.10^5$ | allmählicher Qualitätsverlust |
| 4-Vb | 10 | 3,5 | gut | ab $3.10^5$ | allmählicher Qualitätsverlust |
| 4-Vc | 21 | 25 | mäßig | keine exzellenten Drucke erhältlich | |

## Patentansprüche

1. Zur Herstellung photopolymerisierter Druck- und Reliefplatten sowie Photoresists geeignetes mehrschichtiges, flächenförmiges, lichtempfindliches Aufzeichnungsmaterial, welches in der angegebenen

Reihenfolge übereinanderliegend enthält:

A) eine lichtempfindliche reliefbildende Schicht, in welcher bei der bildmäßigen Belichtung mit aktinischem Licht eine Löslichkeitsdifferenzierung zwischen den belichteten und unbelichteten Bereichen eintritt, so daß die Schicht mit organischen, wäßrig-alkoholischen oder wäßrig-alkalischen flüssigen Medien entwickelt werden kann, wobei diese Schicht (A), bezogen auf ihre Gesamtmenge, aus den folgenden Komponenten besteht:

$a_1$) 20 bis 98,999 Gew.% eines oder mehrerer polymerer Bindemittel,

$a_2$) 0,001 bis 10 Gew.% eines oder mehrerer Photoinitiatoren,

$a_3$) 1 bis 60 Gew.% einer oder mehrerer mit dem Bindemittel ($a_1$) verträglicher, photopolymerisierbare olefinisch ungesättigte Gruppen enthaltender Komponenten und

$a_4$) 0 bis 40 Gew.% eines oder mehrerer Hilfsstoffe;

B) eine lichtdurchlässige, in den betreffenden flüssigen Medien lösliche oder quellbare, nicht klebrige Deckschicht, welche an der Schicht (A) fester haftet als an der Deckfolie (C) und welche von einem reißfeste Filme bildenden Polymeren und den darin enthaltenen Zusatzstoffen gebildet wird;

und

C) einer von der Deckschicht (B) leicht abziehbaren Deckfolie;

dadurch gekennzeichnet, daß die Deckschicht (B), bezogen auf ihre Gesamtmenge, 1 bis 20 Gew.% einer oder mehrerer Verbindungen aus der Gruppe der

$b_1$) tertiären Amine und Amide der allgemeinen Formel I,

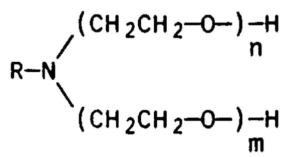

I

worin die Indices und die Variablen die folgende Bedeutung haben:

R — $C_{12}$- bis $C_{18}$-Alkyl, $C_{18}$-Alkenyl, $C_{12}$- bis $C_{18}$-Alkancarbonyl oder $C_{18}$-Alkencarbonyl,

n — eine ganze Zahl von 1 bis 15 und unabhängig hiervon

m — eine ganze Zahl von 1 bis 15;

und/oder aus der Gruppe der

$b_2$) quaternären Ammoniumsalze der allgemeinen Formel II,

$[NR^1R^2R^3R^4]^{\oplus} X^{\ominus}$ II

worin die Variablen die folgende Bedeutung haben:

$X^{\ominus}$ — $Cl^{\ominus}$, $Br^{\ominus}$, $I^{\ominus}$, $R^1$-O-$PO_3H^{\ominus}$, $(R^1\text{-}O)_2PO_2^{\ominus}$, $R^1$-$PO_3^{\ominus}$, $R^1$-$SO_3^{\ominus}$, $R^1$-$COO^{\ominus}$, $CF_3SO_3^{\ominus}$, $R^1$-$OSO_3^{\ominus}$,

$R^1$ — $C_1$- bis $C_4$-Alkyl,

$R^2$ und $R^3$ — $C_1$- bis $C_{20}$-Alkyl,
$-(-CH_2CH_2-O-)_n-H$, worin n eine ganze Zahl von 1 bis 15 bezeichnet und wobei $R^2$ und $R^3$ gleich oder verschieden sein können,

$R^4$ — $-(-CH_2CH_2-O-)_n-H$, worin n eine ganze Zahl von 1 bis 15 bezeichnet,
$C_{12}$-, $C_{14}$-, $C_{16}$- und $C_{18}$-Alkyl,
3-Azatridecan-1-yl bis 3-Azadocosan-1-yl,
4-Azatridecan-1-yl bis 4-Azadocosan-1-yl,
3-Aza-4-oxo-tridecan-1-yl bis 3-Aza-4-oxo-docosan-1-yl,
4-Aza-5-oxo-tridecan-1-yl bis 4-Aza-5-oxo-docosan-1-yl,
3-Oxa-tridecan-1-yl bis 3-Oxa-docosan-1-yl,
4-Oxa-tridecan-1-yl bis 4-Oxadocosan-1-yl,
2-Hydroxy-4-oxa-tridecan-1-yl bis 2-Hydroxy-4-oxa-docosan-1-yl.

**2.** Lichtempfindliches Aufzeichnungsmaterial nach Anspruch 1, worin die Deckschicht (B) aus reißfeste Filme bildenden Polymeren aus der Gruppe der Polyamide, Copolyamide, Polyurethane, Poly(meth)-acrylate, Polyvinylalkohol-alkancarbonsäureester eines Hydrolysegrades von 30 bis 99%. der Cyclokautschuke hohen Cyclisierungsgrades, der Ethylen/Propylen-Copolymerisate, der Homo- und Copolymerisate des Vinylchlorids sowie der Ethylen/ Vinylacetat-Copolymerisate gebildet wird.

**3.** Lichtempfindliches Aufzeichnungsmaterial nach Anspruch 1, worin die tertiären Amine und Amide ($b_1$) der allgemeinen Formel I aus der Gruppe, welche aus N,N-Bis-(2-hydroxyethyl)-N-lauryl-, -N-tridecyl-, -N-myristyl-, -N-pentadecyl-, -N-palmityl-, -N-heptadecyl-, -N-stearyl- und -N-oleylamin sowie aus N,N-Bis-(2-hydroxyethyl)-laurinsäure-, -tridecancarbonsäure-, -myristinsäure-, -pentadecancarbonsäure-, -palmitinsäure-, -heptadecancarbonsäure-, -stearinsäure- und -ölsäureamid besteht, ausgewählt sind.

**4.** Lichtempfindliches Aufzeichnungsmaterial nach Anspruch 1, worin die quaternären Ammoniumsalze ($b_2$) aus der Gruppe der Ammoniumsalze der allgemeinen Formel II ausgewählt sind, worin die Variablen die folgende Bedeutung haben:

| | |
|---|---|
| X | Methylsulfat, Ethylsulfat, |
| $R^1$ | Methyl, Ethyl, |
| $R^2$ und $R^3$ | |
| | Methyl, Ethyl, Lauryl, Myristyl, Palmityl, Stearyl, 2-Hydroxyethyl, |
| $R^4$ | 2-Hydroxyethyl, Lauryl, Myristyl, Palmityl, Stearyl; 2-Laurylamino-, 2-Myristylamino-, 2-Palmitylamino- und 2-Stearylaminoethyl; 3-Laurylamino-, 3-Myristylamino-, 3-Palmitylamino- und 3-Stearylaminopropyl; 2-Laurylamido-, 2-Myristylamido-, 2-Palmitylamido- und 2-Stearylamidoethyl; 3-Laurylamido-, 3-Myristylamido-, 3-Palmitylamido- und 3-Stearylamidopropyl; |
| $R^4$ | 2-Hydroxyethyl, Lauryl, Myristyl, Palmityl, Stearyl; 2-Laurylamino-, 2-Myristylamino-, 2-Palmitylamino- und 2-Stearylaminoethyl; 3-Laurylamino-, 3-Myristylamino-, 3-Palmitylamino- und 3-Stearylaminopropyl; 2-Laurylamido-, 2-Myristylamido-, 2-Palmitylamido- und 2-Stearylamidoethyl; 3-Laurylamido-, 3-Myristylamido-, 3-Palmitylamido- und 3-Stearylamidopropyl; 2-Lauryloxi-, 2-Myristyloxi-, 2-Palmityloxi- und 2-Stearyloxiethyl; 3-Lauryloxi-, 3-Myristyloxi-, 3-Palmityloxi- und 3-Stearyloxipropyl; sowie 3-Lauryloxi-, 3-Myristyloxi-, 3-Palmityloxi- und 3-Stearyloxi-2-hydroxypropyl. |

**5.** Lichtempfindliches Aufzeichnungsmaterial nach einem der Ansprüche 1 bis 4, dadurch gekennzeichnet, daß man hierin als Bindemittel ($a_1$) Polyamide, Copolyamide, Polyalkadiene, Vinylaromat/Alkadien-Copolymerisate und -Blockmischpolymerisate, Alkadien/Acrylnitril-Copolymerisate oder Ethylen/(Meth)-Acrylsäure-Copolymerisate verwendet.

**6.** Lichtempfindliches Aufzeichnungsmaterial nach einem der Ansprüche 1 bis 5, dadurch gekennzeichnet, daß man hierin als photopolymerisierbare olefinisch ungesättigte Gruppen enthaltende Komponenten ($a_3$) Reste verwendet, die mit dem Bindemittel ($a_1$) seitenständig oder endständig verknüpft sind.

**7.** Lichtempfindliches Aufzeichnungsmaterial nach einem der Ansprüche 1 bis 5, dadurch gekennzeichnet, daß man hierin als photopolymerisierbare olefinisch ungesättigte Gruppen enthaltende Komponenten ($a_3$) separat vorliegende Verbindungen (Monomere) verwendet.

**8.** Verfahren zur Herstellung photopolymerisierter Druck- oder Reliefplatten sowie Photoresists durch bildmäßiges Belichten der lichtempfindlichen reliefbildenden Schicht (A) eines Aufzeichnungsmaterials mit aktinischem Licht und anschließendes Auswaschen der unbelichteten Bereiche der bildmäßig belichteten reliefbildenden Schicht (A) mittels organischer, wäßrig-alkoholischer oder wäßrig-alkalischer flüssiger Medien unter Bildung einer Reliefschicht (A'), dadurch gekennzeichnet, daß man hierzu ein mehrschichtiges, flächenförmiges, lichtempfindliches Aufzeichnungsmaterial gemäß einem der Ansprüche 1 bis 7 einsetzt.

## Claims

**1.** A multilayer, sheet-like, photosensitive recording material which is suitable for the production of photopolymerized printing and relief plates and photo-resists and contains, one on top of the other in the stated sequence,

A) a photosensitive relief-forming layer in which a solubility differentiation between the exposed and unexposed parts is induced on imagewise exposure to actinic light, so that the layer can be developed with organic, aqueous alcoholic or aqueous alkaline liquid media, this layer (A) consisting

of the following components, based on its total amount:

$a_1$) from 20 to 98.999% by weight of one or more polymeric binders,

$a_2$) from 0.001 to 10% by weight of one or more photoinitiators,

$a_3$) from 1 to 60% by weight of one or more components compatible with the binder ($a_1$) and containing photopolymerizable olefinically unsaturated groups and

$a_4$) from 0 to 40% by weight of one or more assistants,

B) a nontacky release layer which is transparent to light and soluble or swellable in the relevant liquid media and adheres to the layer (A) more firmly than to the cover sheet (C) and which is formed by a polymer forming strong films and the additives contained therein

and

C) a cover sheet which can be readily removed from the release layer (B),

wherein the release layer (B) contains, based on its total amount, from 1 to 20% by weight of one or more compounds selected from the group consisting of the

$b_1$) tertiary amines and amides of the general formula I

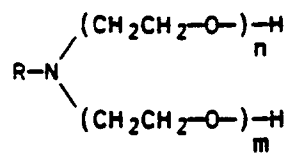

I

where

R is $C_{12}$-$C_{18}$-alkyl, $C_{18}$-alkenyl, $C_{12}$-$C_{18}$-alkanecarbonyl or $C_{18}$-alkenecarbonyl,

n is an integer from 1 to 15 and, independently thereof,

m is an integer from 1 to 15,

and/or selected from the group consisting of the

$b_2$) quaternary ammonium salts of the general formula II

$$[NR^1R^2R^3R^4]^{\oplus}X^{\ominus} \qquad II$$

where $X^{\ominus}$ is $Cl^{\ominus}$, $Br^{\ominus}$, $I^{\ominus}$, $R^1$-O-$PO_3H^{\ominus}$, $(R^1\text{-}O)_2PO_2^{\ominus}$,$R^1$-$PO_3^{\ominus}$, $R^1$-$SO_3^{\ominus}$, $R^1$-$COO^{\ominus}$, $CF_3SO_3^{\ominus}$ or $R^1$-$OSO_3^{\ominus}$,

$R^1$ is $C_1$-$C_4$-alkyl,

$R^2$ and $R^3$ are each $C_1$-$C_{20}$-alkyl or

$-(-CH_2CH_2\text{-}O\text{-})_n$-H, where n is an integer from 1 to 15, and $R^2$ and $R^3$ may be identical or different,

$R^4$ is $-(-CH_2CH_2\text{-}O\text{-})_n$-H, where n is an integer from 1 to 15,

$C_{12}$-, $C_{14}$-, $C_{16}$- or $C_{18}$-alkyl,

3-azatridecan-1-yl to 3-azadocosan-1-yl,

4-azatridecan-1-yl to 4-azadocosan-1-yl,

3-aza-4-oxotridecan-1-yl to 3-aza-4-oxodocosan-1-yl,

4-aza-5-oxotridecan-1-yl to 4-aza-5-oxodocosan-1-yl,

3-oxatridecan-1-yl to 3-oxadocosan-1-yl,

4-oxatridecan-1-yl to 4-oxadocosan-1-yl or

2-hydroxy-4-oxatridecan-1-yl to 2-hydroxy-4-oxadocosan-1-yl.

**2.** A photosensitive recording material as claimed in claim 1, wherein the release layer (B) is formed from polymers forming strong films and selected from the group consisting of polyamides, copolyamides, polyurethanes, poly(meth)acrylates, polyvinyl alkanecarboxylates having a degree of hydrolysis of from 30 to 99%, cyclized rubbers having a high degree of cyclization, ethylene/propylene copolymers, homo- and copolymers of vinyl chloride and ethylene/vinyl acetate copolymers.

**3.** A photosensitive recording material as claimed in claim 1, wherein the tertiary amines and amides ($b_1$) of the general formula I are selected from the group consisting of N,N-bis-(2-hydroxyethyl)-N-laurylamine, N,N-bis-(2-hydroxyethyl)-N-tridecylamine, N,N-bis-(2-hydroxyethyl)-N-myristylamine, N,N-bis-(2-hydroxyethyl)-N-pentadecylamine, N,N-bis-(2-hydroxyethyl)-N-palmitylamine, N,N-bis-(2-hydroxyethyl)-N-heptadecylamine, N,N-bis-(2-hydroxyethyl)-N-stearylamine and N,N-bis-(2-hydroxyethyl)-N-oleylamine and of N,N-bis-(2-hydroxyethyl)-lauramide, N,N-bis-(2-hydroxyethyl)-tridecanecarboxamide,

N,N-bis-(2-hydroxyethyl)-myristamide, N,N-bis-(2-hydroxyethyl)-pentadecanecarboxamide, N,N-bis-(2-hydroxyethyl)-palmitamide, N,N-bis-(2-hydroxyethyl)-heptadecanecarboxamide, N,N-bis-(2-hydroxyethyl)-stearamide and N,N-bis-(2-hydroxyethyl)-oleamide.

**4.** A photosensitive recording material as claimed in claim 1, wherein the quaternary ammonium salts ($b_2$) are selected from the group consisting of the ammonium salts of the general formula II,
where X is methylsulfate or ethylsulfate,
$R^1$ is methyl or ethyl,
$R^2$ and $R^3$ are each methyl, ethyl, lauryl, myristyl, palmityl, stearyl or 2-hydroxyethyl and
$R^4$ is 2-hydroxyethyl, lauryl, myristyl, palmityl, stearyl, 2-laurylaminoethyl, 2-myristylaminoethyl, 2-palmitylaminoethyl or 2-stearylaminoethyl, 3-laurylaminopropyl, 3-myristylaminopropyl, 3-palmitylaminopropyl or 3-stearylaminopropyl, 2-laurylamidoethyl, 2-myristylamidoethyl, 2-palmitylamidoethyl or 2-stearylamidoethyl, 3-laurylamidopropyl, 3-myristylamidopropyl, 3-palmitylamidopropyl or 3-stearylamidopropyl, 2-lauryloxyethyl, 2-myristyloxyethyl, 2-palmityloxyethyl or 2-stearyloxyethyl, 3-lauryloxypropyl, 3-myristyloxypropyl, 3-palmityloxypropyl or 3-stearyloxypropyl, or 3-lauryloxy-2-hydroxypropyl, 3-myristyloxy-2-hydroxypropyl, 3-palmityloxy-2-hydroxypropyl or 3-stearyloxy-2-hydroxypropyl.

**5.** A photosensitive recording material as claimed in any of claims 1 to 4, wherein polyamides, copolyamides, polyalkadienes, vinyl aromatic/alkadiene copolymers and block copolymers, alkadiene/acrylonitrile copolymers or ethylene/(meth)acrylic acid copolymers are used therein as binders ($a_1$).

**6.** A photosensitive recording material as claimed in any of claims 1 to 5, wherein the radicals which are bonded as a side or terminal group to the binder ($a_1$) are used therein as components ($a_3$) containing photopolymerizable olefinically unsaturated groups.

**7.** A photosensitive recording material as claimed in any of claims 1 to 5, wherein separate compounds (monomers) are used therein as components ($a_3$) containing photopolymerizable olefinically unsaturated groups.

**8.** A process for the production of a photopolymerized printing or relief plate or of a photoresist by imagewise exposure of the photosensitive relief-forming layer (A) of a recording material to actinic light and subsequent washing out of the unexposed parts of the imagewise exposed relief-forming layer (A) by means of organic, aqueous alcoholic or aqueous alkaline liquid media with formation of a relief layer (A'), wherein a multilayer, sheet-like, photosensitive recording material as claimed in any of claims 1 to 7 is used for this purpose.

## Revendications

**1.** Matériau d'enregistrement photosensible, planiforme, à couches multiples, convenant à la fabrication de plaques d'impression et plaques en relief photopolymérisées ou de photoréserves, contenant en superposition dans l'ordre indiqué :

A) une couche photosensible formant le relief dans laquelle, à l'exposition à la lumière actinique avec formation d'une image, il apparaît une différence de solubilité entre les régions exposées et les régions non exposées, de sorte que la couche peut être développée à l'aide de milieux liquides organiques hydro-alcooliques ou aqueux alcalins, cette couche A) consistant, sur son poids total, en les composants suivants :

$a_1$) 20 à 98,999% en poids d'un ou plusieurs liants polymères,
$a_2$) 0,001 à 10% en poids d'un ou plusieurs photo-inducteurs,
$a_3$) 1 à 60% en poids d'un ou plusieurs composants contenant des groupes à insaturation oléfinique photopolymérisables, compatibles avec le liant $a_1$), et
$a_4$) 0 à 40% en poids d'un ou pluseiurs produits auxiliaires;

B) une couche de couverture non collante, optiquement transparente, soluble ou gonflable dans les milieux liquides dont il a été question ci-dessus, qui adhère plus solidement à la couche A) qu'à la feuille de couverture C) et qui est constituée d'un polymère formant des pellicules qui résistent à la rupture et des additifs contenus dans ce polymère ;

et

C) une feuille de couverture qui se détache facilement de la couche de couverture B),

- caractérisé en ce que la couche de couverture B) contient, sur son poids total, 1 à 20% en poids d'un ou plusieurs composés du groupe :

b1) des amines et amides tertiaires de formule générale I

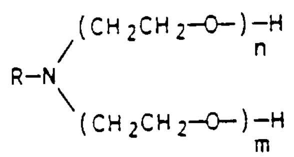

I

dans laquelle les symboles et indices ont les significations suivantes :

R représente un groupe alkyle en C 12 à C 18, alcényle en C 18, alcane-carbonyle en C 12 à 18 ou alcène-carbonyle en C 18,

n est un nombre entier allant de 1 à 15, et, indépendamment de celui-ci,

m est un nombre entier allant de 1 à 15 ;

et/ou du groupe

b2) des sels d'ammonium quaternaires de formule générale II

$[NR^1R^2R^3R^4]^{\oplus} X^{\ominus}$ II

dans laquelle les symboles ont les significations suivantes :

$X^{\ominus}$ représente $Cl^{\ominus}$, $Br^{\ominus}$, $I^{\ominus}$, $R^1\text{-O-}PO_3H^{\ominus}$, $(R^1\text{-O})_2PO_2^{\ominus}$, $R^1\text{-}PO_3^{\ominus}$, $R^1\text{-}SO_3^{\ominus}$, $R^1\text{-}COO^{\ominus}$, $CF_3SO_3^{\ominus}$, $R^1\text{-}OSO_3^{\ominus}$,

$R^1$ représente un groupe alkyle en C 1 - C 4,

$R^2$ et $R^3$ représentent

des groupes alkyle en C 1 - C 20,

des groupes $-(-CH_2\ CH_2\ -0-)_n-H$, dans lesquels n est un nombre entier allant de 1 à 15, $R^2$ et $R^3$ pouvant avoir des significations identiques ou différentes,

$R^4$ représente $-(-CH_2\ CH_2\ -O-)_n-H$, dans lequel n est un nombre entier allant de 1 à 15,

un groupe alkyle en C 12, en C 14, en C 16 et en C 18,

l'un des groupes 3-azatridécane-1-yle à 3-azadocosane-1-yle,

l'un des groupes 4-azatridécane-1-yle à 4-azadocosane-1-yle,

l'un des groupes 3-aza-4-oxo-tridécane-1-yle à 3-aza-4-oxo-docosane-1-yle,

- l'un des groupes 4-aza-5-oxo-tridécane-1-yle à 4-aza-5-oxo-docosane-1-yle,

l'un des groupes 3-oxa-tridécane-1-yle à 3-oxa-docosane-1-yle,

l'un des groupes 4-oxa-tridécane-1-yle à 4-oxa-docosane-1-yle

l'un des groupes 2-hydroxy-4-oxa-tridécane-1-yle à 2-hydroxy-4-oxa-docosane-1-yle.

**2.** Matériau d'enregistrement photosensible selon la revendication 1, dans lequel la couche de couverture B) est constituée de polymères, formant des pellicules qui résistent à la rupture, du groupe des polyamides, des copolyamides, des polyuréthannes, des poly(méth)acrylates, des poly-(esters alcanoïques de l'alcool vinylique), à un taux d'hydrolyse de 30 à 99%, des cyclocaoutchoucs à fort taux de cyclisation, des copolymères éthylène/propylène, des homo- et co-polymères du chlorure de vinyle et des copolymères éthylène/acétate de vinyle.

**3.** Matériau d'enregistrement photosensible selon la revendication 1, dans lequel les amines et amides tertiaires $b_1$) de formule générale I sont choisis dans le groupe consistant en les N,N-bis-(2-hydroxyéthyl)-N-lauryl, -N-tridécyl,-N-myristyl-, -N-pentadécyl-, -N-palmityl-, -N-heptadécyl,- -N-stéaryl- et -N-oléylamines et en les N,N-bis-(2-hydroxyéthyl)-lauramide, -tridécane-carboxamide, - myristamide, -pentadécane-carboxamide, -palmitamide, -heptadécane-carboxamide, -stéaramide et -oléamides.

**4.** Matériau d'enregistrement photosensible selon la revendication 1, dans lequel les sels d'ammonium quaternaire $b_2$) sont choisis dans le groupe des sels d'ammonium de formule générale II dans laquelle les symboles ont les significations suivantes :

X représente un groupe méthylsulfate, éthylsulfate,

$R^1$ représente un groupe méthyle, éthyle,

$R^2$ et $R^3$ représentent des groupes méthyle, éthyle, lauryle, myristyle, palmityle, stéaryle, 2-hydroxyéthyle,

$R^4$ représente un groupe 2-hydroxyéthyle, lauryle, myristyle, palmityle, stéaryle ; 2-laurylamino-, 2-myristylamino-, 2-palmitylamino- ou 2-stéarylaminoéthyle ; 3-laurylamino-, 3-myristylamino-, 3-palmitylamino- ou 3-stéarylamino-propyle ; 2-laurylamido-, 2-myristylamido-, 2-palmitylamido- et 2-stéarylamido-éthyle ; 3-laurylamido-, 3-myristylamido-, 3-palmitylamido- et 3-stéarylamido-propyle ; 2-lauryloxy-, 2-myristyloxy, -2-palmityloxy- et 2-stéaryloxy-éthyle ; 3-lauryloxy-, 3-myristyloxy-, 3-palmityloxy- et 3-stéaryloxy-propyle, ainsi que 3-lauryloxy-, 3-myristyloxy-, 3-palmityloxy - et 3-stéaryloxy-2-hydroxypropyle.

**5.** Matériau d'enregistrement photosensible selon une des revendications 1 à 4, caractérisé en ce que l'on utilise, en tant que liants a1), des polyamides, des copolyamides, des polyalcadiènes, des copolymères et copolymères séquencés vinylaromatique/alcadiène, des copolymères alcadiène/acrylonitrile ou des copolymères éthylène/acide (méth) acrylique.

**6.** Matériau d'enregistrement photosensible selon une des revendications 1 à 5, caractérisé en ce que l'on utilise, en tant que composants $a_3$) contenant des groupes à insaturation oléfinique photopolymérisables, des radicaux reliés au liant $a_1$) en position latérale ou en position terminale.

**7.** Matériau d'enregistrement photosensible selon une des revendications 1 à 5, caractérisé en ce que l'on utilise, en tant que composants $a_3$) contenant des groupes à insaturation oléfinique photopolymérisables, des composés séparés (monomères).

**8.** Procédé de préparation de plaques d'impression ou en relief photopolymérisées et de photo-réserves par exposition à la lumière actinique avec formation d'une image de la couche photosensible formant le relief A) d'un matériau d'enregistrement, lavage subséquent des régions non exposées de la couche A) formant le relief, exposée avec formation d'une image, à l'aide de milieux liquides organiques, hydro-alcooliques ou aqueux alcalins avec formation d'une couche en relief A'), caractérisé en ce que l'on utilise à cet effet un matériau d'enregistrement photosensible planiforme à plusieurs couches selon une des revendications 1 à 7.